# EUROPEAN PATENT APPLICATION

(11) **EP 2 983 018 A1**
(43) Date of publication of application: **10.02.2016**
(21) Application number: 14778775.8
(22) Date of filing: 03.04.2014
(51) Int. Cl.: G02B 5/02, H01L 51/50, H05B 33/02

(54) **OPTICAL FILM AND SURFACE LIGHT EMITTING BODY**

(30) Priority: 05.04.2013 JP 2013079071
(71) Applicant: Mitsubishi Rayon Co., Ltd., Tokyo 100-8253 (JP)
(72) Inventor: MORINAKA, Takeshi, Yokohama-shi Kanagawa 230-0053 (JP); HATTORI, Toshiaki, Yokohama-shi Kanagawa 230-0053 (JP); OKUNO, Daichi, Yokohama-shi Kanagawa 230-0053 (JP)
(74) Representative: TBK
(86) International application number: PCT/JP2014/059826
(87) International publication number: WO 2014/163135

(57) **Abstract**

This optical film comprises: a recessed and projected structure layer that forms one surface of the optical film; and an adhesive layer that forms the other surface of the optical film. The recessed and projected structure layer contains 1-28% by mass of first fine light diffusing particles relative to the total mass of the recessed and projected structure layer, and the adhesive layer contains 1-40% by mass of second fine light diffusing particles relative to the total mass of the adhesive layer. This surface light emitting body comprises the above-described optical film.

## Description

### TECHNICAL FIELD

The present invention relates to an optical film and a surface light emitting body.

This application is based upon and claims the benefit of priority of the prior Japanese Patent Application No. 2013-079071 filed in the Japanese Patent Office on April 5, 2013, the entire contents of which are incorporated herein by reference.

### BACKGROUND ART

Among the surface light emitting bodies, an organic EL (electroluminescence) light emitting device is expected to be used in next-generation lighting as an alternative of a flat panel display, a fluorescent lamp, or the like.

The structure of the organic EL light emitting device has been diversified from those having a simple structure in which only an organic thin film serving as a light emitting layer is sandwiched between two electrodes to those having a structure which includes a light emitting layer and multilayered organic thin films. Examples of the latter multilayered structure may include those fabricated by stacking a hole transport layer, a light emitting layer, an electron transport layer, and a cathode on an anode provided on a glass substrate. The layers sandwiched between the anode and the cathode are all constituted by organic thin films, and the thickness of each organic thin film is significantly thin to be several tens of nm.

The organic EL light emitting device is a stacked body of thin films, and the angle of total reflection of light between the thin films is determined by the difference in refractive index between the materials of the respective thin films. At present, approximately 80% of the light generated in the light emitting layer is confined to the inside of the organic EL light emitting device and it is not possible to extract the light to the outside. Specifically, the critical angle, θ_{c}, is 41.8° when the refractive index of the glass substrate is 1.5 and the refractive index of an air layer is 1.0, and the light with an angle of incidence smaller than this critical angle, θ_{c}, exits from the glass substrate to the air layer but the light with an angle of incidence greater than this critical angle, θ_{c}, is totally reflected to be confined to the inside of the glass substrate. Hence, it is desired to extract the light confined to the inside of the glass substrate on the surface of the organic EL light emitting device to the outside of the glass substrate, namely, to improve the light extraction efficiency or the normal brightness.

In addition, with regard to an organic EL light emitting device that isotropically emits light, it is desired to suppress the exiting angle dependency of the wavelength of light exited from the organic EL light emitting device as well as to improve the light extraction efficiency or the normal brightness. In other words, it is desired that the difference in exiting angle depending on the wavelength is small, that is, the wavelength dependency of the distribution of light exited from the glass substrate is suppressed as small as possible when the light exited from the light emitting layer passes through the glass substrate and exits from the glass substrate.

In order to solve the above problem, a surface light emitting body obtained by bonding an optical film containing fine particles in a relief structure to an organic EL light emitting device is proposed in Patent Document 1. In addition, a surface light emitting body obtained by bonding an optical film having a relief structure to an organic EL light emitting device via a fine particle-containing pressure sensitive adhesive is proposed in Patent Document 2.

### CITATION LIST

### PATENT DOCUMENT

Patent Document 1: JP 2010-212204 A
Patent Document 2: JP 2012-18873 A

### SUMMARY OF THE INVENTION

### PROBLEM TO BE SOLVED BY THE INVENTION

However, the surface light emitting body proposed in Patent Document 1 has a problem that the optical film is warped when the content of fine particles is high and the exiting angle dependency of the exited light wavelength is not sufficiently suppressed when the content of fine particles is low. In addition, the surface light emitting body proposed in Patent Document 2 has a problem that it has a poor light extraction efficiency or normal brightness.

In particular, a great quantity of warpage of the optical film becomes a factor to significantly decrease the productivity in the process of bonding an optical film to an organic EL light emitting device.

Accordingly, an object of the invention is to provide an optical film which achieves the suppression of warpage, an improvement in light extraction efficiency or normal brightness of a surface light emitting body, and the suppression of exiting angle dependency of the exited light wavelength in a surface light emitting body.

### MEANS FOR SOLVING PROBLEM

[1] An optical film including a relief structure layer forming one surface of the optical film and a pressure sensitive adhesive layer forming the other surface of the optical film, in which the relief structure layer contains first light-diffusing fine particles at from 1 to 28% by mass with respect to a total mass of the relief structure layer and the pressure sensitive adhesive layer contains second light-diffusing fine particles at from 1 to 40% by mass with respect to a total mass of the pressure sensitive adhesive layer.
[2] The optical film according to [1], in which a content of the second light-diffusing fine particles with respect to a total mass of the pressure sensitive adhesive layer is from 20 to 40% by mass.
[3] The optical film according to claim [1] or [2], in which a volume average particle size of the first light-diffusing fine particles contained in the relief structure layer is from 0.5 to 20 µm.
[4] The optical film according to any one of [1] to [3], in which a volume average particle size of the second light-diffusing fine particles contained in the pressure sensitive adhesive layer is from 0.5 to 20 µm.
[5] The optical film according to any one of [1] to [4], in which a difference between a refractive index of a material constituting the relief structure layer and a refractive index of the first light-diffusing fine particles contained in the relief structure layer is from 0.02 to 0.30.
[6] The optical film according to any one of [1] to [5], in which a difference between a refractive index of a material constituting the pressure sensitive adhesive layer and a refractive index of the second light-diffusing fine particles contained in the pressure sensitive adhesive layer is from 0.02 to 0.30.
[7] The optical film according to any one of [1] to [6], in which a ratio of a content of the second light-diffusing fine particles contained in the pressure sensitive adhesive layer with respect to a total mass of the pressure sensitive adhesive layer to a content of the first light-diffusing fine particles contained in the relief structure layer with respect to a total mass of the relief structure layer is from 0.05 to 10.
[8] The optical film according to any one of [1] to [7], in which a ratio of a volume average particle size of the second light-diffusing fine particles contained in the pressure sensitive adhesive layer to a volume average particle size of the first light-diffusing fine particles contained in the relief structure layer is from 0.125 to 1.25.
[9] The optical film according to any one of [1] to [8], in which a ratio of a refractive index of the second light-diffusing fine particles contained in the pressure sensitive adhesive layer to a refractive index of the first light-diffusing fine particles contained in the relief structure layer is from 0.80 to 1.05.
[10] The optical film according to any one of [1] to [9], in which the optical film further includes a base layer coming in contact with the relief structure layer, and a total thickness of the relief structure layer and the base layer is from 20 to 80 µm.
[11] The optical film according to any one of [1] to [10], in which a thickness of the pressure sensitive adhesive layer is from 5 to 50 µm.
[12] The optical film according to any one of [1] to [11], in which a ratio of a volume average particle size of the second light-diffusing fine particles contained in the pressure sensitive adhesive layer to a thickness of the pressure sensitive adhesive layer is from 0.05 to 0.5.
[13] The optical film according to any one of [1] to [12], in which a material constituting the relief structure layer is at least one kind of material selected from the group consisting of an acrylic resin, a styrene resin, an olefin resin, a polycarbonate resin, a silicone resin, an epoxy resin, and a polyester resin.
[14] The optical film according to any one of [1] to [13], in which a material constituting the pressure sensitive adhesive layer is an acrylic pressure sensitive adhesive.
[15] The optical film according to any one of [1] to [14], in which a material of the first light-diffusing fine particles contained in the relief structure layer is at least one kind of material selected from the group consisting of a silicone resin, an acrylic resin, a styrene resin, a urethane resin, a melamine resin, and an epoxy resin.
[16] The optical film according to any one of [1] to [15], in which a material of the second light-diffusing fine particles contained in the pressure sensitive adhesive layer is at least one kind of material selected from the group consisting of a silicone resin, an acrylic resin, a styrene resin, a urethane resin, a melamine resin, and an epoxy resin.
[17] The optical film according to any one of [1] to [16], in which the optical film further includes a substrate, and the pressure sensitive adhesive layer, the substrate, and the relief structure layer are sequentially stacked.
[18] A surface light emitting body including the optical film according to any one of [1] to [17] and an EL light emitting device.
[19] A method for producing an optical film, including: providing a pressure sensitive adhesive layer containing second light-diffusing fine particles at from 1 to 40% by mass with respect to a total mass of the pressure sensitive adhesive layer on one surface of a substrate; and providing a relief structure layer containing first light-diffusing fine particles at from 1 to 28% by mass with respect to a total mass of the relief structure layer on the other surface of the substrate.

In addition, the invention relates to a surface light emitting body including the optical film.

### EFFECT OF THE INVENTION

According to the optical film of the invention, the warpage is suppressed, the light extraction efficiency or normal brightness of a surface light emitting body is improved, and the exiting angle dependency of the exited light wavelength is suppressed.

In addition, the surface light emitting body of the invention exhibits excellent productivity, has an improved light extraction efficiency or normal brightness, and exhibits suppressed exiting angle dependency of the exited light wavelength.

### BRIEF DESCRIPTION OF DRAWINGS

Fig. 1 is a schematic diagram illustrating an example of a cross section of the optical film of the invention;
Fig. 2A is a schematic diagram of a disposition example of a relief structure of the optical film of the invention viewed from above the optical film;
Fig. 2B is a schematic diagram of a disposition example of a relief structure of the optical film of the invention viewed from above the optical film;
Fig. 2C is a schematic diagram of a disposition example of a relief structure of the optical film of the invention viewed from above the optical film;
Fig. 2D is a schematic diagram of a disposition example of a relief structure of the optical film of the invention viewed from above the optical film;
Fig. 2E is a schematic diagram of a disposition example of a relief structure of the optical film of the invention viewed from above the optical film;
Fig. 2F is a schematic diagram of a disposition example of a relief structure of the optical film of the invention viewed from above the optical film;
Fig. 3A is a schematic diagram illustrating an example of a relief structure of the optical film of the invention;
Fig. 3B is a schematic diagram illustrating an example of a relief structure of the optical film of the invention;
Fig. 4 is a schematic diagram of an example of the optical film of the invention viewed from above the optical film;
Fig. 5 is a diagram illustrating an example of an apparatus for producing the optical film of the invention; and
Fig. 6 is a schematic diagram illustrating an example of the surface light emitting body of the invention.

### MODE(S) FOR CARRYING OUT THE INVENTION

Hereinafter, embodiments of the invention will be described with reference to the accompanying drawings, but the invention is not limited to these drawings.

### (Optical film 10)

An optical film 10 of the invention includes a relief structure layer that forms one surface of the optical film 10 and a pressure sensitive adhesive layer that forms the other surface of the optical film 10.

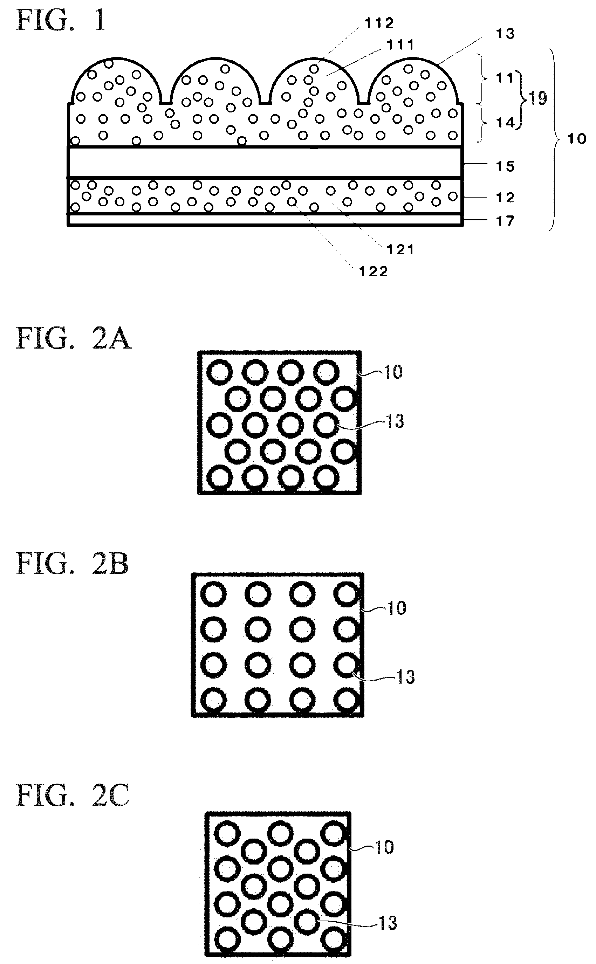

Examples of the optical film 10 of the invention may include the optical film 10 and the like as illustrated in Fig. 1.

The optical film 10 illustrated in Fig. 1 includes a substrate 15, a surface layer 19, a pressure sensitive adhesive layer 12, and a protective film 17. The surface layer 19 includes a relief structure layer 11 and a base layer 14. The relief structure layer 11 is constituted by first fine particles (first light-diffusing fine particles) 112 and a material 111 although it will be described in detail later.

In the optical film 10 of the invention, it is preferable to provide the base layer 14 as illustrated in Fig. 1 so that the shape of the relief structure 13 of the relief structure layer 11 is excellently maintained. In addition, in the optical film 10 of the invention, it is preferable to provide the relief structure layer 11 on one surface of the substrate 15 and the pressure sensitive adhesive layer 12 on the other surface of the substrate 15 from the viewpoint of excellent handling property and productivity. In consideration of these, the optical film 10 of the invention is particularly preferably a film that is fabricated by sequentially stacking the pressure sensitive adhesive layer 12, the substrate 15, the base layer 14, and the relief structure layer 11.

### (Relief structure layer 11)

A protrusion (convex portion) or a recess (concave portion) of the relief structure 13 to be described later is disposed on the relief structure layer 11.

The protrusion or recess of the relief structure layer 11 is preferably a protrusion from the viewpoint of excellent productivity of the optical film 10. In the present specification, it is simply represented as the relief structure 13 in both cases in which either of the protrusion or the recess of the relief structure 13 is present and both of them are present together.

Examples of the shape of the relief structure 13 may include a spherical segment shape, a truncated spherical segment shape, an ellipsoid spherical segment shape (a shape obtained by cutting a spheroid in one plane), a truncated ellipsoid spherical segment shape (a shape obtained by cutting a spheroid in two planes parallel to each other), a pyramidal shape, a truncated pyramidal shape, a conical shape, a truncated conical shape, a roof shape related to these (a shape in which a spherical segment shape, a truncated spherical segment shape, an ellipsoid spherical segment shape, a truncated ellipsoid spherical segment shape, a pyramidal shape, a truncated pyramidal shape, a conical shape, or a truncated conical shape extends along the bottom surface portion). These shapes of the relief structure 13 may be used singly or two or more kinds thereof may be used concurrently. Among these shapes of the relief structure 13, a spherical shape such as a spherical segment shape, a truncated spherical segment shape, an ellipsoid spherical segment shape, or a truncated ellipsoid spherical segment shape is preferable and a spherical segment shape and an ellipsoid spherical segment shape are more preferable from the viewpoint of an excellent light extraction efficiency or normal brightness of the surface light emitting body.

Incidentally, the spherical shape may not be a perfect spherical shape but may be a substantially spherical shape. The substantially spherical shape is a shape in which the surface of a spherical shape is deviated from the surface of the virtual perfect sphere circumscribed by the spherical shape in the normal direction from the center of the virtual perfect sphere, and the amount of deviation may be from 0 to 20% with respect to the radius of the virtual perfect sphere.

In addition, in the present specification, in a case in which a shape is represented as an "ellipse", the ellipse also includes a circular shape in which a perfect circle is extended in one direction or multiple directions.

The disposition examples of the relief structure 13 are illustrated in Fig. 2A to Fig. 2F.

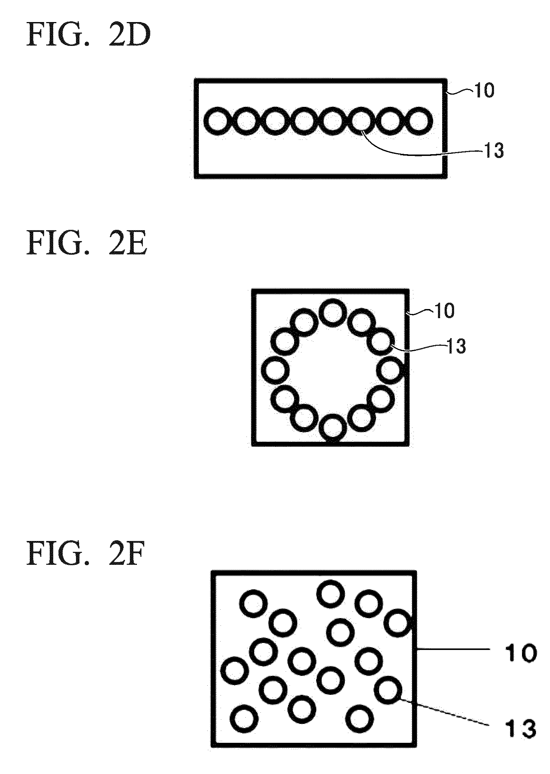

Examples of disposition of the relief structure 13 may include a hexagonal arrangement (Fig. 2A), a rectangular arrangement (Fig. 2B), a rhombic arrangement (Fig. 2C), a linear arrangement (Fig. 2D), a circular arrangement (Fig. 2E), and a random disposition (Fig. 2F). The hexagonal arrangement means that the relief structure 13 is disposed on the respective vertices and middle points of a hexagon and the disposition of the hexagon is continuously arranged. The rectangular arrangement means that the relief structure 13 is disposed on the respective vertices of a rectangle and the disposition of the rectangle is continuously arranged. The rhombic arrangement means that the relief structure 13 is disposed on the respective vertices of a rhombus and the disposition of the rhombus is continuously arranged. The linear arrangement means that the relief structure 13 is disposed in a straight line. The circular arrangement means that the relief structure 13 is disposed along a circle.

Among these dispositions of the relief structure 13, a hexagonal arrangement, a rectangular arrangement, and a rhombic arrangement are preferable and a hexagonal arrangement and a rectangular arrangement are more preferable from the viewpoint of an excellent light extraction efficiency or normal brightness of the surface light emitting body.

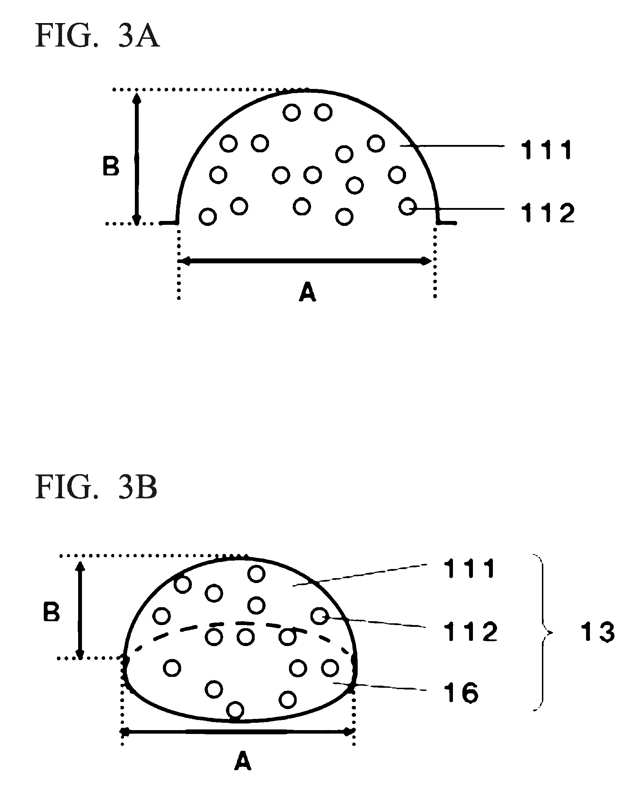

Examples of the relief structure 13 are illustrated in Fig. 3A and Fig. 3B.

In the present specification, a bottom surface portion 16 of the relief structure 13 refers to the virtual planar portion surrounded by the outer circumferential edge of the bottom portion (the contact surface with the base layer 14 in the case of having the base layer 14) of the relief structure 13.

In addition, in the present specification, the longest diameter, A, of the bottom surface portion 16 of the relief structure 13 refers to the length of the longest part of the bottom surface portion 16 of the relief structure 13, and the average longest diameter, Aₐᵥₑ, of the bottom surface portion 16 of the relief structure 13 is a value obtained by taking an image of the surface having the relief structure 13 of the optical film 10 using an electron microscope, measuring the longest diameter, A, of the bottom surface portion 16 of the relief structure 13 at arbitrary five positions, and averaging the values measured.

Furthermore, in the present specification, the height, B, of the relief structure 13 refers to the height from the bottom surface portion 16 to the highest part of the relief structure 13 in the case of a protrusion structure, and it refers to the height from the bottom surface portion 16 to the lowest part of the relief structure 13 in the case of a recess structure. The average height, Bₐᵥₑ, of the relief structure 13 is a value obtained by taking an image of the cross section of the optical film 10 using an electron microscope, measuring the height, B, of the relief structure 13 at arbitrary five positions, and averaging the values measured.

The average longest diameter, Aₐᵥₑ, of the bottom surface portion 16 of the relief structure 13 is preferably from 0.5 to 150 µm, more preferably from 1 to 130 µm, and even more preferably from 2 to 100 µm from the viewpoint of an excellent light extraction efficiency or normal brightness of the surface light emitting body.

The average height, Bₐᵥₑ, of the relief structure 13 is preferably from 0.25 to 75µm, more preferably from 0.5 to 65 µm, and even more preferably from 1 to 50 µm from the viewpoint of an excellent light extraction efficiency or normal brightness of the surface light emitting body.

Incidentally, the thickness of the surface layer 19 obtained by summing the relief structure layer 11 and the base layer 14 is preferably from 5 to 120 µm, more preferably from 10 to 110 µm, even more preferably from 15 to 100 µm, and even more preferably from 20 to 80 µm from the viewpoint of being able to contain first fine particles 112 and excellent light diffusing property. Here, the thickness of the surface layer 19 is calculated as follows. An image of the cross section of the optical film 10 is taken using an electron microscope, the dimensions from the bottom surface portion of the base layer 14 to the highest part of the relief structure 13 are measured at arbitrary five positions, and the average value of the values measured is determined in a case in which the relief structure 13 is a protrusion structure.

The aspect ratio of the relief structure 13 is preferably from 0.3 to 1.4, more preferably from 0.35 to 1.3, and even more preferably from 0.4 to 1.0 from the viewpoint of an excellent light extraction efficiency or normal brightness of the surface light emitting body.

Incidentally, the aspect ratio of the relief structure 13 is calculated from the "average height, Bₐᵥₑ, of relief structure 13/average longest diameter, Aₐᵥₑ, of bottom surface portion 16 of relief structure 13".

Examples of the shape of the bottom surface portion 16 of the relief structure 13 may include a circular shape and an elliptical shape. These shapes of the bottom surface portion 16 of the relief structure 13 may be used singly or two or more kinds thereof may be used concurrently. Among these shapes of the bottom surface portion 16 of the relief structure 13, a circular shape and an elliptical shape are preferable and a circular shape is more preferable from the viewpoint of an excellent light extraction efficiency or normal brightness of the surface light emitting body.

Incidentally, the circular shape may not be a perfect circle but may be a substantially circular shape. A substantially circular shape is a shape in which the surface of a circular shape is deviated from the circumference of a virtual perfect circle circumscribed by the circular shape in the normal direction of the virtual perfect circle, and the amount of deviation may be from 0 to 20% with respect to the radius of the virtual perfect circle.

In addition, in the present specification, in a case in which a shape is represented as an "ellipse", the ellipse also includes a circular shape in which a perfect circle is extended in one direction or multiple directions.

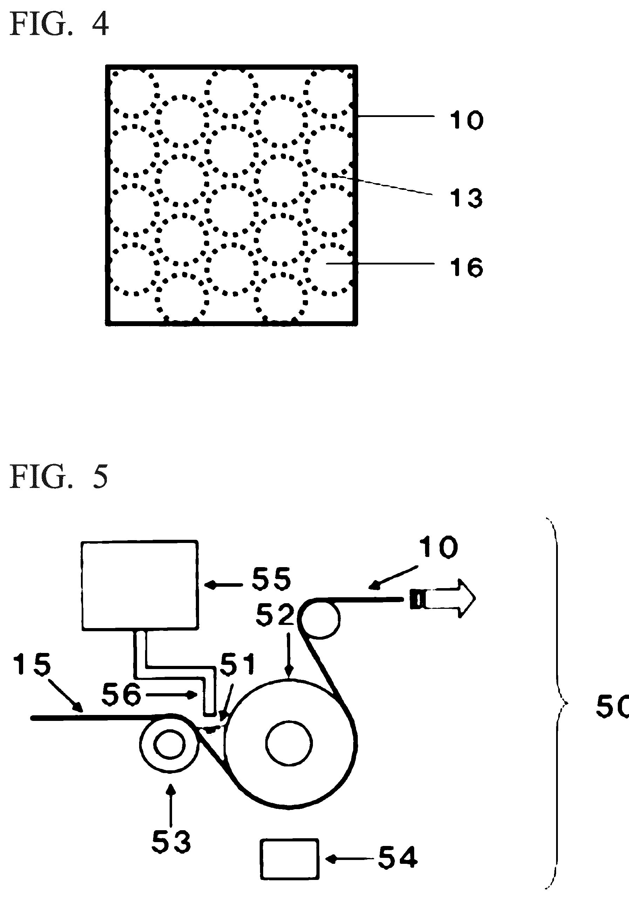

An example of the optical film viewed from above is illustrated in Fig. 4.

The proportion of the area of the bottom surface portion 16 of the relief structure 13 (the area surrounded by the dotted line in Fig. 4) to the area of the optical film 10 (the area surrounded by the solid line in Fig. 4) is preferably from 20 to 99%, more preferably from 25 to 95%, and even more preferably from 30 to 93% from the viewpoint of an excellent light extraction efficiency or normal brightness of the surface light emitting body.

Incidentally, in a case in which all the bottom surface portions 16 of the relief structure 13 are circular shapes having the same size, the maximum value of the proportion of the area of the bottom surface portion 16 of the relief structure 13 to the area of the optical film 10 is about 91%.

The relief structure layer 11 is constituted by first fine particles (first light-diffusing fine particles) 112 and a material 111.

The material 111 constituting the relief structure layer is not particularly limited as long as it is a resin that has a high light transmittance in the visible light wavelength region (approximately from 400 to 700 nm), and examples thereof may include a resin and glass. Among these materials of the material 111 constituting the relief structure layer, a resin is preferable from the viewpoint of handling property and excellent productivity of the optical film. Incidentally, in the present specification, the "material constituting the relief structure layer" does not contain the first fine particles. The transmittance of the material 111 constituting the relief structure layer is preferably 50% or more as the value measured in conformity with JIS K7361.

The resin is not particularly limited as long as it is a resin having a high light transmittance in the visible light wavelength region (approximately from 400 to 700 nm), and examples thereof may include an acrylic resin; a polycarbonate resin; a polyester resin such as polyethylene terephthalate, polybutylene terephthalate, and polyethylene naphthalate; a styrene resin such as polystyrene or an ABS resin; and a vinyl chloride resin. Among these resins, an acrylic resin is preferable from the viewpoint of a high light transmittance in the visible light wavelength region and excellent heat resistance, mechanical properties, and molding processability.

The resin is preferably a cured resin obtained by curing an active energy ray-curable composition by irradiating with an active energy ray from the viewpoint of excellent productivity of the optical film 10.

Examples of the active energy ray may include ultraviolet light, an electron beam, X-ray, infrared rays, and visible light. Among these active energy rays, ultraviolet light and an electron beam are preferable and ultraviolet light is more preferable from the viewpoint of excellent curability of the active energy ray-curable composition and being able to suppress deterioration of the optical film 10.

The active energy ray-curable composition is not particularly limited as long as it is curable by an active energy ray, but an active energy ray-curable composition containing a polymerizable monomer (A), a cross-linkable monomer (B), and a polymerization initiator (C) is preferable from the viewpoint of excellent handling property and curability of the active energy ray-curable composition and excellent physical properties such as flexibility, heat resistance, abrasion resistance, solvent resistance, and light transmitting property of the optical film 10.

Examples of the polymerizable monomer (A) may include a (meth)acrylate such as methyl (meth)acrylate, ethyl (meth)acrylate, n-propyl (meth)acrylate, iso-propyl (meth)acrylate, n-butyl (meth)acrylate, iso-butyl (meth)acrylate, sec-butyl (meth)acrylate, tert-butyl (meth)acrylate, n-hexyl (meth)acrylate, cyclohexyl (meth)acrylate, n-octyl (meth)acrylate, 2-ethylhexyl (meth)acrylate, isononyl (meth)acrylate, dodecyl (meth)acrylate, tridecyl (meth)acrylate, stearyl (meth)acrylate, alkyl (meth)acrylate, phenyl (meth)acrylate, benzyl (meth)acrylate, phenoxyethyl (meth)acrylate, isobornyl (meth)acrylate, glycidyl (meth)acrylate, tetrahydrofurfuryl (meth)acrylate, norbornyl (meth)acrylate, adamantyl (meth)acrylate, dicyclopentenyl (meth)acrylate, dicyclopentanyl (meth)acrylate, tetracyclododecanyl (meth)acrylate, cyclohexanedimethanol mono(meth)acrylate, 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 2-methoxyethyl (meth)acrylate, 2-ethoxyethyl (meth)acrylate, 3-methoxybutyl (meth)acrylate, butoxyethyl (meth)acrylate, methoxy triethylene glycol (meth)acrylate, methoxy dipropylene glycol (meth) crylate, 2-(meth)acryloyloxymethyl-2-methylbicycloheptane, 4-(meth)acryloyloxymethyl-2-methyl-2-ethyl-1,3-dioxolane, 4-(meth)acryloyloxymethyl-2-methyl-2-isobutyl-1,3-dioxolane, trimethylolpropane formal (meth)acrylate, ethylene oxide-modified phosphoric acid (meth)acrylate, or caprolactone-modified phosphoric acid (meth)acrylate; (meth)acrylic acid; (meth)acrylonitrile; a (meth)acrylamide such as (meth)acrylamide, N-dimethyl (meth)acrylamide, N-diethyl (meth)acrylamide, N-butyl (meth)acrylamide, dimethylaminopropyl (meth)acrylamide, N-methylol(meth)acrylamide, N-methoxymethyl(meth)acrylamide, N-butoxymethyl(meth)acrylamide, (meth)acryloylmorpholine, hydroxyethyl(meth)acrylamide, or methylenebis(meth)acrylamide; an epoxy (meth)acrylate such as a compound obtained by reacting (meth)acrylic acid or any derivative thereof with a bisphenol type epoxy resin obtained by the condensation reaction between a bisphenol (bisphenol A, bisphenol F, bisphenol S, tetrabromobisphenol A, or the like) and epichlorohydrin; an aromatic vinyl compound such as styrene and α-methylstyrene; a vinyl ether such as vinyl methyl ether, vinyl ethyl ether, 2-hydroxyethyl vinyl ether; a carboxylic acid vinyl ester such as vinyl acetate or vinyl butyrate; and an olefin such as ethylene, propylene, butene, or isobutene. These polymerizable monomers (A) may be used singly or two or more kinds thereof may be used concurrently. Among these polymerizable monomers (A), a (meth) acrylate, an epoxy (meth)acrylate, an aromatic vinyl compound, and an olefin are preferable and a (meth)acrylate and an epoxy (meth)acrylate are more preferable from the viewpoint of excellent handling property and curability of the active energy ray-curable composition and excellent physical properties such as flexibility, heat resistance, abrasion resistance, solvent resistance, and light transmitting property of the optical film 10.

In the present specification, the term "(meth)acrylate" refers to an acrylate or a methacrylate.

The content of the polymerizable monomer (A) in the active energy ray-curable composition is preferably from 0.5 to 60% by mass, more preferably from 1 to 57% by mass, and even more preferably from 2 to 55% by mass with respect to the total mass of the active energy ray-curable composition. The handling property of the active energy ray-curable composition is excellent when the content of the polymerizable monomer (A) is 0.5% by mass or more. In addition, the crosslinkability and curability of the active energy ray-curable composition are excellent and the solvent resistance of the optical film 10 is excellent when the content of the polymerizable monomer (A) is 60% by mass or less.

Examples of the cross-linkable monomer (B) may include a hexa(meth)acrylate such as dipentaerythritol hexa(meth)acrylate or caprolactone-modified dipentaerythritol hexa(meth)acrylate; a penta(meth)acrylate such as dipentaerythritol hydroxy penta(meth)acrylate or caprolactone-modified dipentaerythritol hydroxy penta(meth)acrylate; a tetra(meth)acrylate such as ditrimethylolpropane tetra(meth)acrylate, pentaerythritol tetra(meth)acrylate, pentaerythritol ethoxy-modified tetra(meth)acrylate, dipentaerythritol hexa(meth)acrylate, dipentaerythritol penta(meth)acrylate, or tetramethylolmethane tetra(meth)acrylate; a tri(meth)acrylate such as trimethylolpropane tri(meth)acrylate, tris ethoxylated trimethylolpropane tri(meth)acrylate, pentaerythritol tri(meth)acrylate, ethoxylated pentaerythritol tri(meth)acrylate, tris(2-(meth)acryloyloxyethyl) isocyanurate, trimethylolpropane tri(meth)acrylate modified by an aliphatic hydrocarbon having from 2 to 5 carbon atoms, or isocyanuric acid ethylene oxide-modified tri(meth)acrylate; a di(meth)acrylate such as triethylene glycol di(meth)acrylate, diethylene glycol di(meth)acrylate, 1,3-butylene glycol di(meth)acrylate, 1,4-butanediol di(meth)acrylate, 1,5-pentanediol di(meth)acrylate, 1,6-hexanediol di(meth)acrylate, nonanediol di(meth)acrylate, neopentyl glycol di(meth)acrylate, methylpentanediol di(meth)acrylate, diethylpentanediol di(meth)acrylate, hydroxypivalic acid neopentyl glycol di(meth)acrylate, tetraethylene glycol di(meth)acrylate, tripropylene glycol di(meth)acrylate, polybutylene glycol di(meth)acrylate, tricyclodecanedimethanol di(meth)acrylate, 2,2-bis(4-(meth)acryloxypolyethoxyphenyl)propane, 2,2-bis(4-(meth)acryloxyethoxyphenyl)propane, 2,2-bis(4-(3-(meth)acryloxy-2-hydroxypropoxy)phenyl)propane, 1,2-bis(3-(meth)acryloxy-2-hydroxypropoxy)ethane, 1,4-bis(3-(meth)acryloxy-2-hydroxypropoxy)butane, bis(2-(meth)acryloyloxyethyl)-2-hydroxyethyl isocyanurate, cyclohexane dimethanol di(meth)acrylate, dimethylol tricyclodecane di(meth)acrylate, hydroxypivalic acid neopentyl glycol di(meth)acrylate, polyethoxylated cyclohexanedimethanol di(meth)acrylate, polypropoxylated cyclohexanedimethanol di(meth)acrylate, polyethoxylated bisphenol A di(meth)acrylate, polypropoxylated bisphenol A di(meth)acrylate, hydrogenated bisphenol A di(meth)acrylate, polyethoxylated hydrogenated bisphenol A di(meth)acrylate, polypropoxylated hydrogenated bisphenol A di(meth)acrylate, bis-phenoxyfluoreneethanol di(meth)acrylate, neopentyl glycol-modified trimethylolpropane di(meth)acrylate, di(meth)acrylate of ε-caprolactone adduct of hydroxypivalic acid neopentyl glycol, di(meth)acrylate of γ-butyrolactone adduct of hydroxypivalic acid neopentyl glycol, di(meth)acrylate of caprolactone adduct of neopentyl glycol, di(meth)acrylate of caprolactone adduct of butylene glycol, di(meth)acrylate of caprolactone adduct of cyclohexanedimethanol, di(meth)acrylate of caprolactone adduct of dicyclopentanediol, di(meth)acrylate of ethylene oxide adduct of bisphenol A, di(meth)acrylate of propylene oxide adduct of bisphenol A, di(meth)acrylate of caprolactone adduct of bisphenol A, di(meth)acrylate of caprolactone adduct of hydrogenated bisphenol A, di(meth)acrylate of caprolactone adduct of bisphenol F, or isocyanuric acid ethylene oxide-modified di(meth)acrylate; a diallyl compound such as diallyl phthalate, diallyl terephthalate, diallyl isophthalate, or diethylene glycol diallyl carbonate; allyl (meth)acrylate; divinylbenzene; methylenebisacrylamide; a polyester di(meth)acrylate such as a compound obtained by the reaction of a polyhydric alcohol (ethylene glycol, hexanediol, polyethylene glycol, or polytetramethylene glycol) and (meth)acrylic acid or any derivative thereof with a polybasic acid (phthalic acid, succinic acid, hexahydrophthalic acid, tetrahydrophthalic acid, terephthalic acid, azelaic acid, or adipic acid); a urethane polyfunctional (meth)acrylate such as a compound obtained by reacting a diisocyanate compound (tolylene diisocyanate, isophorone diisocyanate, xylene diisocyanate, dicyclohexylmethane diisocyanate, or hexamethylene diisocyanate) with a hydroxyl group-containing (meth)acrylate (a polyfunctional (meth)acrylate such as 2-hydroxyethyl (meth)acrylate, 2-hydroxypropyl (meth)acrylate, 4-hydroxybutyl (meth)acrylate, or pentaerythritol tri(meth)acrylate) or a compound obtained by adding a diisocyanate compound to the hydroxyl group of an alcohol (one kind or two or more kinds of an alkane diol, a polyether diol, a polyester diol, and a spiroglycol compound) and reacting the remaining isocyanate group with a hydroxyl group-containing (meth)acrylate; a divinyl ether such as diethylene glycol divinyl ether or triethylene glycol divinyl ether; and a diene such as butadiene, isoprene, or dimethyl butadiene. These cross-linkable monomers (B) may be used singly or two or more kinds thereof may be used concurrently. Among these cross-linkable monomers (B), a hexa(meth)acrylate, a penta(meth)acrylate, a tetra(meth)acrylate, a tri(meth)acrylate, a di(meth)acrylate, a diallyl compound, an allyl (meth)acrylate, a polyester di(meth)acrylate, and a urethane polyfunctional (meth)acrylate are preferable and a hexa(meth)acrylate, a penta(meth)acrylate, a tetra(meth)acrylate, a tri(meth)acrylate, a di(meth)acrylate, a polyester di(meth)acrylate, and a urethane polyfunctional (meth)acrylate are more preferable from the viewpoint of excellent physical properties such as flexibility, heat resistance, abrasion resistance, solvent resistance, and light transmitting property of the optical film 10.

The content of the cross-linkable monomer (B) in the active energy ray-curable composition is preferably from 30 to 98% by mass, more preferably from 35 to 97% by mass, and even more preferably from 40 to 96% by mass with respect to the total mass of the active energy ray-curable composition. The crosslinkability and curability of the active energy ray-curable composition are excellent and the solvent resistance of the optical film 10 is excellent when the content of the cross-linkable monomer (B) is 30% by mass or more. In addition, the flexibility of the optical film 10 is excellent when the content of the cross-linkable monomer (B) is 98% by mass or less.

Examples of the polymerization initiator (C) may include a carbonyl compound such as benzoin, benzoin methyl ether, benzoin ethyl ether, benzoin isopropyl ether, benzoin isobutyl ether, acetoin, benzil, benzophenone, p-methoxybenzophenone, 2,2-diethoxyacetophenone, and α,α-dimethoxy-α-phenylacetophenone, benzyl dimethyl ketal, methylphenyl glyoxylate, ethylphenyl glyoxylate, 4,4'-bis(dimethylamino)benzophenone, 1-hydroxycyclohexyl phenyl ketone, 2-hydroxy-2-methyl-1-phenylpropan-1-one, or 2-ethylanthraquinone; a sulfur compound such as tetramethylthiuram monosulfide or tetramethylthiuram disulfide; and an acylphosphine oxide such as 2,4,6-trimethylbenzoyldiphenylphosphine oxide or benzoyldiethoxyphosphine oxide. These polymerization initiators (C) may be used singly or two or more kinds thereof may be used concurrently. Among these polymerization initiators (C), a carbonyl compound and an acylphosphine oxide are preferable and a carbonyl compound is more preferable from the viewpoint of excellent handling property and curability of the active energy ray-curable composition and excellent light transmitting property of the optical film 10.

The content of the polymerization initiator (C) in the active energy ray-curable composition is preferably from 0.1 to 10% by mass, more preferably from 0.5 to 8% by mass, and even more preferably from 1 to 5% by mass with respect to the total mass of the active energy ray-curable composition. The handling property and curability of the active energy ray-curable composition are excellent when the content of the polymerization initiator (C) is 0.1% by mass or more. In addition, the light transmitting property of the optical film 10 is excellent when the content of the polymerization initiator (C) is 10% by mass or less.

The refractive index of the material 111 constituting the relief structure layer 11 is preferably from 1.40 to 2.00, more preferably from 1.43 to 1.95, and even more preferably from 1.46 to 1.90 from the viewpoint of excellent light transmitting property of the optical film 10. The refractive index of the material 111 constituting the relief structure layer 11 is a value measured using the sodium D line at 20°C.

The content of the material 111 constituting the relief structure layer 11 with respect to the total mass of the relief structure layer 11 is from 72 to 99% by mass, preferably from 75 to 98% by mass, more preferably from 77 to 97% by mass, and even more preferably from 79% to 96% by mass. The warpage of the optical film 10 is suppressed and the light extraction efficiency or normal brightness of the surface light emitting body is excellent when the content of the material 111 constituting the relief structure layer 11 with respect to the total mass of the relief structure layer 11 is 72% by mass or more. In addition, the light diffusibility of the optical film 10 is excellent and the exiting angle dependency of the exited light wavelength in the surface light emitting body can be suppressed when the content of the material 111 constituting the relief structure layer 11 with respect to the total mass of the relief structure layer is 99% by mass or less.

The first fine particles 112 contained in the relief structure layer 11 are not particularly limited as long as they are fine particles having a light diffusing effect in the visible light wavelength region (approximately from 400 to 700 nm), and known fine particles can be used. The first fine particles 112 contained in the relief structure layer 11 may be used singly or two or more kinds thereof may be used concurrently.

Examples of the material of the first fine particles 112 may include a metal such as gold, silver, silicon, aluminum, magnesium, zirconium, titanium, zinc, germanium, indium, tin, antimony, or cerium; a metal oxide such as silicon oxide, aluminum oxide, magnesium oxide, zirconium, titanium oxide, zinc oxide, germanium oxide, indium oxide, tin oxide, indium tin oxide, antimony oxide, or cerium oxide; a metal hydroxide such as aluminum hydroxide; a metal carbonate such as magnesium carbonate; a metal nitride such as silicon nitride; and a resin such as an acrylic resin, a styrene resin, a silicone resin, a urethane resin, a melamine resin, or an epoxy resin. These materials of the fine particles may be used singly or two or more kinds thereof may be used concurrently. Among these materials of the fine particles, silicon, aluminum, magnesium, silicon oxide, aluminum oxide, magnesium oxide, aluminum hydroxide, magnesium carbonate, an acrylic resin, a styrene resin, a silicone resin, a urethane resin, a melamine resin, and an epoxy resin are preferable and particles of silicon oxide, aluminum oxide, aluminum hydroxide, magnesium carbonate, an acrylic resin, a styrene resin, a silicone resin, a urethane resin, a melamine resin, and an epoxy resin are preferable from the viewpoint of excellent handling property at the time of producing the optical film 10.

The refractive index of the first fine particles 112 contained in the relief structure layer 11 is preferably from 1.30 to 2.00, more preferably from 1.35 to 1.95, and even more preferably from 1.40 to 1.90 from the viewpoint of excellent light transmitting property of the optical film 10. The refractive index of the first fine particles 112 is a value measured using the sodium D line at 20°C.

The volume average particle size of the first fine particles 112 contained in the relief structure layer 11 is preferably from 0.5 to 20 µm, more preferably from 1 to 15 µm, and even more preferably from 1.5 to 10 µm. It is possible to effectively scatter the light in the visible wavelength region when the volume average particle size of the first fine particles 112 contained in the relief structure layer 11 is 0.5 µm or more. In addition, it is possible to suppress the exiting angle dependency of the exited light wavelength in the surface light emitting body when the volume average particle size of the first fine particles 112 contained in the relief structure layer 11 is 20 µm or less.

Incidentally, in the present specification, the volume average particle size adopts the value measured using a Coulter counter.

Examples of the shape of the first fine particles 112 contained in the relief structure layer 11 may include a spherical shape, a columnar shape, a cubic shape, a cuboid shape, a pyramidal shape, a conical shape, a star shape, and an irregular shape. These shapes of the first fine particles 112 contained in the relief structure layer 11 may be used singly or two or more kinds thereof may be used concurrently. Among these shapes of the first fine particles 112 contained in the relief structure layer 11, a spherical shape, a cubic shape, a cuboid shape, a pyramidal shape, and a star shape are preferable and a spherical shape is more preferable from the viewpoint of being able to effectively scatter the light in the visible wavelength region.

The content of the first fine particles 112 contained in the relief structure layer 11 with respect to the total mass of the relief structure layer 11 is from 1 to 28% by mass, preferably from 2 to 25% by mass, more preferably from 3 to 23% by mass, and even more preferably from 4 to 21% by mass. The light diffusibility of the optical film 10 is excellent and the exiting angle dependency of the exited light wavelength in the surface light emitting body can be suppressed when the content of the first fine particles 112 contained in the relief structure layer 11 with respect to the total mass of the relief structure layer 11 is 1% by mass or more. The warpage of the optical film 10 is suppressed and the light extraction efficiency or normal brightness of the surface light emitting body is excellent when the content of the first fine particles 112 contained in the relief structure layer 11 with respect to the total mass of the relief structure layer 11 is 28% by mass or less.

Incidentally, the content of the first fine particles 112 contained in the relief structure layer 11 with respect to the total mass of the relief structure layer 11 may be substantially the same as or different from the content of the first fine particles 112 contained in the surface layer 19 with respect to the total mass of the surface layer 19.

The light diffusing effect by the first fine particles 112 is generated as there is a difference in refractive index between the material 111 and the first fine particles 112. The difference in refractive index between the material 111 and the first fine particles 112 is preferably from 0.02 to 0.30, more preferably from 0.03 to 0.25, and even more preferably from 0.04 to 0.20 from the viewpoint of being able to suppress the exiting angle dependency of the exited light wavelength in the surface light emitting body.

Examples of the combination of the material 111 and the first fine particles 112 may include a combination of an acrylic resin as the material 111 and silicon fine particles as the first fine particles 112, a combination of an acrylic resin as the material 111 and aluminum fine particles as the first fine particles 112, a combination of an acrylic resin as the material 111 and magnesium fine particles as the first fine particles 112, a combination of an acrylic resin as the material 111 and silicon oxide fine particles as the first fine particles 112, a combination of an acrylic resin as the material 111 and aluminum oxide fine particles as the first fine particles 112, a combination of an acrylic resin as the material 111 and magnesium oxide fine particles as the first fine particles 112, a combination of an acrylic resin as the material 111 and aluminum hydroxide fine particles as the first fine particles 112, a combination of an acrylic resin as the material 111 and magnesium carbonate fine particles as the first fine particles 112, a combination of an acrylic resin as the material 111 and acrylic resin fine particles as the first fine particles 112, a combination of an acrylic resin as the material 111 and styrene resin fine particles as the first fine particles 112, a combination of an acrylic resin as the material 111 and silicone resin fine particles as the first fine particles 112, a combination of an acrylic resin as the material 111 and urethane resin fine particles as the first fine particles 112, a combination of an acrylic resin as the material 111 and melamine resin fine particles as the first fine particles 112, a combination of an acrylic resin as the material 111 and epoxy resin fine particles as the first fine particles 112, a combination of a polycarbonate resin as the material 111 and silicon fine particles as the first fine particles 112, a combination of a polycarbonate resin as the material 111 and aluminum fine particles as the first fine particles 112, a combination of a polycarbonate resin as the material 111 and magnesium fine particles as the first fine particles 112, a combination of a polycarbonate resin as the material 111 and silicon oxide fine particles as the first fine particles 112, a combination of a polycarbonate resin as the material 111 and aluminum oxide fine particles as the first fine particles 112, a combination of a polycarbonate resin as the material 111 and magnesium oxide fine particles as the first fine particles 112, a combination of a polycarbonate resin as the material 111 and aluminum hydroxide fine particles as the first fine particles 112, a combination of a polycarbonate resin as the material 111 and magnesium carbonate fine particles as the first fine particles 112, a combination of a polycarbonate resin as the material 111 and acrylic resin fine particles as the first fine particles 112, a combination of a polycarbonate resin as the material 111 and styrene resin fine particles as the first fine particles 112, a combination of a polycarbonate resin as the material 111 and silicone resin fine particles as the first fine particles 112, a combination of a polycarbonate resin as the material 111 and urethane resin fine particles as the first fine particles 112, a combination of a polycarbonate resin as the material 111 and melamine resin fine particles as the first fine particles 112, a combination of a polycarbonate resin as the material 111 and epoxy resin fine particles as the first fine particles 112, a combination of polyethylene terephthalate as the material 111 and silicon fine particles as the first fine particles 112, a combination of polyethylene terephthalate as the material 111 and aluminum fine particles as the first fine particles 112, a combination of polyethylene terephthalate as the material 111 and magnesium fine particles as the first fine particles 112, a combination of polyethylene terephthalate as the material 111 and silicon oxide fine particles as the first fine particles 112, a combination of polyethylene terephthalate as the material 111 and aluminum oxide fine particles as the first fine particles 112, a combination of polyethylene terephthalate as the material 111 and magnesium oxide fine particles as the first fine particles 112, a combination of polyethylene terephthalate as the material 111 and aluminum hydroxide fine particles as the first fine particles 112, a combination of polyethylene terephthalate as the material 111 and magnesium carbonate fine particles as the first fine particles 112, a combination of polyethylene terephthalate as the material 111 and acrylic resin fine particles as the first fine particles 112, a combination of polyethylene terephthalate as the material 111 and styrene resin fine particles as the first fine particles 112, a combination of polyethylene terephthalate as the material 111 and silicone resin fine particles as the first fine particles 112, a combination of polyethylene terephthalate as the material 111 and urethane resin fine particles as the first fine particles 112, a combination of polyethylene terephthalate as the material 111 and melamine resin fine particles as the first fine particles 112, and a combination of polyethylene terephthalate as the material 111 and epoxy resin fine particles as the first fine particles 112. Among the combinations of the material 111 and the first fine particles 112, a combination of an acrylic resin as the material 111 and silicon fine particles as the first fine particles 112, a combination of an acrylic resin as the material 111 and aluminum fine particles as the first fine particles 112, a combination of an acrylic resin as the material 111 and magnesium fine particles as the first fine particles 112, a combination of an acrylic resin as the material 111 and silicon oxide fine particles as the first fine particles 112, a combination of an acrylic resin as the material 111 and aluminum oxide fine particles as the first fine particles 112, a combination of an acrylic resin as the material 111 and magnesium oxide fine particles as the first fine particles 112, a combination of an acrylic resin as the material 111 and aluminum hydroxide fine particles as the first fine particles 112, a combination of an acrylic resin as the material 111 and magnesium carbonate fine particles as the first fine particles 112, a combination of an acrylic resin as the material 111 and acrylic resin fine particles as the first fine particles 112, a combination of an acrylic resin as the material 111 and styrene resin fine particles as the first fine particles 112, a combination of an acrylic resin as the material 111 and silicone resin fine particles as the first fine particles 112, a combination of an acrylic resin as the material 111 and urethane resin fine particles as the first fine particles 112, a combination of an acrylic resin as the material 111 and melamine resin fine particles as the first fine particles 112, and a combination of an acrylic resin as the material 111 and epoxy resin fine particles as the first fine particles 112 are preferable and a combination of an acrylic resin as the material 111 and silicon oxide fine particles as the first fine particles 112, a combination of an acrylic resin as the material 111 and aluminum oxide fine particles as the first fine particles 112, a combination of an acrylic resin as the material 111 and aluminum hydroxide fine particles as the first fine particles 112, a combination of an acrylic resin as the material 111 and magnesium carbonate fine particles as the first fine particles 112, a combination of an acrylic resin as the material 111 and acrylic resin fine particles as the first fine particles 112, a combination of an acrylic resin as the material 111 and styrene resin fine particles as the first fine particles 112, a combination of an acrylic resin as the material 111 and silicone resin fine particles as the first fine particles 112, a combination of an acrylic resin as the material 111 and urethane resin fine particles as the first fine particles 112, a combination of an acrylic resin as the material 111 and melamine resin fine particles as the first fine particles 112, and a combination of an acrylic resin as the material 111 and epoxy resin fine particles as the first fine particles 112 are more preferable from the viewpoint of excellent heat resistance, mechanical properties, and molding processability of the optical film 10, a preferred range of the difference in refractive index, and an excellent light extraction efficiency of the surface light emitting body.

The relief structure layer 11 may contain other components in addition to the material 111 or the first fine particles 112 in a range in which the performance is not impaired.

Examples of the other components may include various kinds of additives such as a mold releasing agent, a flame retardant, an antistatic agent, a leveling agent, an antifouling property improver, a dispersion stabilizer, a viscosity modifier, a light stabilizer, an antioxidant, and a colorant such as a dye or a pigment.

The content of the other components with respect to the total mass of the relief structure layer 11 is preferably 3% by mass or less, more preferably 2% by mass or less, and even more preferably 1% by mass or less. It is possible to suppress the deterioration in performance of the optical film 10 when the content of the other components in the relief structure layer 11 is 3% by mass or less with respect to the total mass of the materials constituting the relief structure layer 11.

In the optical film 10 of the invention, a protective film may be provided on the surface having the relief structure 13 in order to protect the relief structure 13 and to improve the handling property of the optical film 10. The protective film may be peeled off from the optical film 10 when using the optical film 10.

Examples of the protective film may include a known protective film.

### (Base layer 14)

The base layer 14 may be provided between the relief structure layer 11 and the substrate 15 in order to maintain the shape of the relief structure 13 of the relief structure layer 11.

It is preferable that the material of the base layer 14 has the same composition as the relief structure layer 11 from the viewpoint of excellent productivity of the optical film 10.

The thickness of the base layer 14 is preferably from 3 to 70 µm, more preferably from 5 to 60 µm, and even more preferably from 10 to 50 µm. It is possible to suppress the exiting angle dependency of the exited light wavelength in the surface light emitting body as the base layer 14 has the same composition (containing the first fine particles) as the relief structure layer 11 when the thickness of the base layer 14 is 3 µm or more. In addition, the warpage of the optical film 10 is suppressed and the light extraction efficiency or normal brightness of the surface light emitting body is excellent when the thickness of the base layer 14 is 40 µm or less. Incidentally, the thickness of the base layer 14 in the present embodiment is an average value of the thicknesses at arbitrary five points on the base layer 14.

### (Substrate 15)

The substrate 15 may be provided between the relief structure layer 11 (the base layer 14 in the case of having the base layer 14) and the pressure sensitive adhesive layer 12 in order to enhance the handling property and productivity of the optical film 10.

As the substrate 15, a substrate that transmits an active energy ray is preferable from the viewpoint of excellent curability of the active energy ray-curable composition. Moreover, it is preferable that the substrate 18 transmits visible light in order to allow light to reach the surface relief structure layer 11. Specifically, it is preferable that the transmittance of visible light passing through the substrate 18 with respect to visible light incident on the substrate 18 is 50% or more. Incidentally, the light transmittance is a value measured in conformity with JIS K7361.

Examples of the material of the substrate 15 may include an acrylic resin; a polycarbonate resin; a polyester resin such as polyethylene terephthalate, polybutylene terephthalate, or polyethylene naphthalate; a styrene resin such as polystyrene or a ABS resin; a vinyl chloride resin; a cellulose resin such as diacetyl cellulose or triacetyl cellulose; an imide resin such as polyimide or polyamide-imide; and glass. Among these materials of the substrate 15, an acrylic resin, a polycarbonate resin, a polyester resin, a styrene resin, a cellulose resin, and an imide resin are preferable and an acrylic resin, a polycarbonate resin, a polyester resin, and an imide resin are more preferable from the viewpoint of excellent flexibility and excellent active energy ray transmitting property.

The thickness of the substrate 15 is preferably from 10 to 1,000 µm, more preferably from 20 to 500 µm, and even more preferably from 25 to 300 µm from the viewpoint of excellent curability of the active energy ray-curable composition.

The substrate 15 may be subjected to the adhesion promoting treatment of the surface of the substrate 15 in order to improve the adhesive property between the relief structure layer 11 (the base layer 14 in the case of having the base layer 14) and the substrate 15 if necessary.

Examples of the method for the adhesion promoting treatment may include a method to form an adhesion promoting layer composed of a polyester resin, an acrylic resin, and a urethane resin on the surface of the substrate 15 and a method to subject the surface of the substrate 15 to the surface roughening treatment.

The substrate 15 may be subjected to the surface treatment for the prevention of static charge, the prevention of reflection, and the prevention of adhesion between the substrates in addition to the adhesion promoting treatment if necessary.

### (Pressure sensitive adhesive layer 12)

The pressure sensitive adhesive layer 12 is constituted by second fine particles (second light-diffusing fine particles) 122 and a material 121.

The material 121 that constitutes the pressure sensitive adhesive layer 12 is not particularly limited as long as it can be bonded to an EL light emitting device 30 and the like, and examples thereof may include an acrylic pressure sensitive adhesive, a natural rubber-based pressure sensitive adhesive, a synthetic rubber-based pressure sensitive adhesive, a silicone-based pressure sensitive adhesive, a polyurethane-based pressure sensitive adhesive, and an epoxy-based pressure sensitive adhesive. These materials 121 constituting the pressure sensitive adhesive layer 12 may be used singly or two or more kinds thereof may be used concurrently. Among the materials 121 constituting the pressure sensitive adhesive layer 12, an acrylic pressure sensitive adhesive is preferable from the viewpoint of a high pressure sensitive adhesive force and excellent weather resistance, flexibility, and heat resistance of the optical film 10.

Incidentally, in the present specification, the "material constituting the pressure sensitive adhesive layer" does not contain the second fine particles.

It is preferable that the interface is in optical adhesion when bonding the pressure sensitive adhesive layer 12 to the EL light emitting device 30 and the like.

Examples of the acrylic pressure sensitive adhesive may include a copolymer obtained by copolymerizing a monomer composition containing an alkyl (meth)acrylate to be the main component, a polar monomer, and if necessary, a crosslinking agent.

Examples of the alkyl (meth)acrylate may include methyl (meth)acrylate, ethyl (meth)acrylate, n-propyl (meth)acrylate, iso-propyl (meth)acrylate, n-butyl (meth)acrylate, iso-butyl (meth)acrylate, sec-butyl (meth)acrylate, tert-butyl (meth)acrylate, n-hexyl (meth)acrylate, cyclohexyl (meth)acrylate, n-octyl (meth)acrylate, 2-ethylhexyl (meth)acrylate, isononyl (meth)acrylate, dodecyl (meth)acrylate, tridecyl (meth)acrylate, and stearyl (meth)acrylate. These alkyl (meth)acrylates may be used singly or two or more kinds thereof may be used concurrently. Among these alkyl (meth)acrylates, n-butyl acrylate and 2-ethylhexyl acrylate are preferable since the glass transition temperature is low and the pressure sensitive adhesive force is high even at a low temperature.

Examples of the polar monomer may include a hydroxyl group-containing monomer such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, or 4-hydroxybutyl (meth)acrylate; a carboxyl group-containing monomer such as (meth)acrylic acid, maleic acid, fumaric acid, or itaconic acid; a nitrogen-containing monomer such as N-vinylpyrrolidone, N-vinylcaprolactam, acryloylmolpholine, or (meth)acrylamide; and an epoxy group-containing monomer such as glycidyl (meth)acrylate. These polar monomers may be used singly or two or more kinds thereof may be used concurrently. These polar monomers act as a crosslinking point in the case of conducting the copolymerization using a crosslinking agent.

Examples of the crosslinking agent may include an isocyanate crosslinking agent such as tolylene diisocyanate, hexamethylene diisocyanate, trimethylolpropane tolylene diisocyanate, or diphenylmethane triisocyanate; an epoxy crosslinking agent such as bisphenol A, an epichlorohydrin type epoxy resin, ethylene glycol glycidyl ether, polyethylene glycol diglycidyl ether, or glycerin diglycidyl ether; an amine crosslinking agent such as hexamethylenediamine, triethyldiamine, or polyethyleneimine; a metal chelate crosslinking agent in which acetyl acetone or ethyl acetoacetate coordinates a polyvalent metal such as aluminum, iron, zinc, tin, titanium, or nickel; and an aziridine cross-linking agent such as N,N'-diphenylmethane-4,4'-bis(1-aziridinecarboxamide), N,N'-toluene-2,4-bis(1-aziridinecarboxamide), triethylenemelamine, bis-isophthaloyl-1-(2-methylaziridine), or tri-1-aziridinylphosphine oxide. These crosslinking agents may be used singly or two or more kinds thereof may be used concurrently.

The content of the crosslinking agent with respect to the total mass of the monomer composition is preferably from 0.01 to 20% by mass, more preferably from 0.05 to 15% by mass. It is possible to suppress that the pressure sensitive adhesive layer 12 juts out when being bonded to the EL light emitting device 30 and the like as the material 121 constituting the pressure sensitive adhesive layer 12 is not too soft when the content of the crosslinking agent with respect to the total mass of the monomer composition is 0.01% by mass or more. The pressure sensitive adhesive force is high when the content of the crosslinking agent with respect to the total mass of the monomer composition is 20% by mass or less.

The mass average molecular weight of the copolymer is preferably from 300,000 to 2,000,000 and more preferably from 500,000 to 1,500,000 from the viewpoint of a high pressure sensitive adhesive force and a high shear force.

Examples of the polymerization method of the monomer composition may include a bulk polymerization method, a solution polymerization method, a suspension polymerization method, and an emulsion polymerization method.

A polymerization initiator may be used when polymerizing the monomer composition if necessary.

Examples of the polymerization initiator may include an azo polymerization initiator such as azobisisobutyronitrile; a peroxide polymerization initiator such as lauroyl peroxide or benzoyl peroxide; a benzophenone polymerization initiator such as benzophenone; a thioxanthone polymerization initiator such as 2-methylthioxanthone; and a benzoin ether polymerization initiator such as benzoin ethyl ether. These polymerization initiators may be used singly or two or more kinds thereof may be used concurrently. Among polymerization initiators, an azo polymerization initiator such as azobisisobutyronitrile is preferable from the viewpoint of excellent polymerizability.

Examples of the method for stacking the pressure sensitive adhesive layer 12 may include a method in which the material 121 constituting the pressure sensitive adhesive layer 12 is dissolved in a solvent, and the second fine particles 122 to be contained in the pressure sensitive adhesive layer is dispersed in the solution thus obtained, the resulting solution is coated on the substrate 15, and the solvent is dried.

Examples of the solvent for dissolving the material 121 constituting the pressure sensitive adhesive layer 12 may include toluene, ethyl acetate, and methyl ethyl ketone. These solvents may be singly or two or more kinds thereof may be used concurrently.

The solution in which the material 121 constituting the pressure sensitive adhesive layer 12 is dissolved in a solvent may contain other components in a range in which the performance is not impaired.

Examples of the other components may include various kinds of additives such as a viscosity modifier, a plasticizer, a filler, a ultraviolet absorber, a flame retardant, an antistatic agent, a light stabilizer, an antioxidant, and a colorant such as a dye or a pigment.

The viscosity of the solution in which the material 121 constituting the pressure sensitive adhesive layer 12 is dissolved in a solvent is preferably from 500 to 6,000 mPa·s and more preferably from 1,000 to 5,000 mPa·s at 23°C. The dispersion stability of the second fine particles 122 contained in the pressure sensitive adhesive layer is excellent when the viscosity of the solution in which the material 121 constituting the pressure sensitive adhesive layer 12 is dissolved in a solvent is 500 mPa·s or more. In addition, it is easy to stack the pressure sensitive adhesive layer 21 when the viscosity of the solution in which the material 121 constituting the pressure sensitive adhesive layer 12 is dissolved in a solvent is 6,000 mPa·s or less.

The thickness of the pressure sensitive adhesive layer 12 is preferably from 5 to 50 µm, more preferably from 7 to 40 µm, and even more preferably from 10 to 30 µm. The adhesive property with a material to be bonded is excellent when the thickness of the pressure sensitive adhesive layer 12 is 5 µm or more. In addition, it is easy to stack the pressure sensitive adhesive layer 21 when the thickness of the pressure sensitive adhesive layer 12 is 50 µm or less. Incidentally, the thickness of the pressure sensitive adhesive layer 12 in the present embodiment is the average value of the thicknesses at arbitrary five points on the pressure sensitive adhesive layer 12.

The refractive index of the material 121 constituting the pressure sensitive adhesive layer 12 is preferably close to the refractive index a basal plate such as glass in order to bond the pressure sensitive adhesive layer 12 to the basal plate such as glass on the surface of the EL light emitting device 30 and the like, and specifically it is preferably from 1.40 to 2.00, more preferably from 1.43 to 1.95, and even more preferably from 1.46 to 1.90.

The content of the material 121 constituting the pressure sensitive adhesive layer 12 with respect to the total mass of the pressure sensitive adhesive layer 12 is from 60 to 99% by mass, preferably from 62 to 98% by mass, more preferably from 65 to 97% by mass, and even more preferably from 68 to 96% by mass. The light transmitting property of the optical film 10 is excellent and the light extraction efficiency or normal brightness of the surface light emitting body is excellent when the content of the material 121 constituting the pressure sensitive adhesive layer 12 in the pressure sensitive adhesive layer 12 is 60% by mass or more. In addition, the light diffusibility of the optical film 10 is excellent and the exiting angle dependency of the exited light wavelength in the surface light emitting body can be suppressed when the content of the material 121 constituting the pressure sensitive adhesive layer 12 in the pressure sensitive adhesive layer 12 is 99% by mass or less.

As the material, volume average particle size, and shape of the second fine particles 122 contained in the pressure sensitive adhesive layer 12, the same ones as those of the first fine particles 112 contained in the relief structure layer 11 previously described can be used, and the preferred ranges are the same for the same reason.

The volume average particle size and shape of the materials of the first fine particles 112 and the second fine particles 122 may be the same as or different from each other, respectively.

Incidentally, the ratio of the refractive index of the second fine particles 122 contained in the pressure sensitive adhesive layer 12 to the refractive index of the first fine particles 112 contained in the relief structure layer 11 is preferably from 0.80 to 1.05.

In addition, the ratio of the volume average particle size of the second fine particles 122 contained in the pressure sensitive adhesive layer 12 to the thickness of the pressure sensitive adhesive layer 12 is from 0.05 to 0.5.

The refractive index of the second fine particles 122 contained in the pressure sensitive adhesive layer 12 is preferably from 1.30 to 2.00, more preferably from 1.35 to 1.95, and even more preferably from 1.40 to 1.90 from the viewpoint of excellent light transmitting property of the optical film 10.

In addition, the ratio of the refractive index of the second fine particles 122 contained in the pressure sensitive adhesive layer 12 to the refractive index of the first fine particles 112 contained in the relief structure layer 11 is preferably from 0.80 to 1.05.

The content of the second fine particles 122 contained in the pressure sensitive adhesive layer 12 with respect to the total mass of the pressure sensitive adhesive layer 12 is from 1 to 40% by mass, preferably from 2 to 38% by mass, more preferably from 3 to 35% by mass, and even more preferably from 4 to 32% by mass. The light diffusibility of the optical film 10 is excellent and the exiting angle dependency of the exited light wavelength in the surface light emitting body can be suppressed when the content of the second fine particles 122 contained in the pressure sensitive adhesive layer 12 with respect to the total mass of the pressure sensitive adhesive layer 12 is 1% by mass or more. In addition, the light transmitting property of the optical film 10 is excellent and the light extraction efficiency or normal brightness of the surface light emitting body is excellent when the content of the second fine particles 122 contained in the pressure sensitive adhesive layer 12 with respect to the total mass of the pressure sensitive adhesive layer 12 is 40% by mass or less.

The light diffusing effect by the second fine particles 122 is generated as there is a difference in refractive index between the material 121 and the second fine particles 122. The difference in refractive index between the material 121 and the second fine particles 122 is preferably from 0.02 to 0.30, more preferably from 0.03 to 0.25, and even more preferably from 0.04 to 0.20 from the viewpoint of being able to suppress the exiting angle dependency of the exited light wavelength in the surface light emitting body.

Examples of the combination of the material 121 and the second fine particles 122 may include the combinations of the material 111 and the first fine particles 112 previously described, and the preferred range is the same for the same reason.

In addition, it is preferable that the ratio of the content of the second fine particles 122 contained in the pressure sensitive adhesive layer 12 with respect to the total mass of the pressure sensitive adhesive layer 12 to the content of the first fine particles 112 contained in the relief structure layer 11 with respect to the total mass of the relief structure layer 11 is from 0.05 to 10.

Furthermore, the pressure sensitive adhesive layer 12 may have a double layer structure. Specifically, the pressure sensitive adhesive layer 12 may include a first layer and a second layer which have different contents of the material 121 and the second fine particles 122 constituting the pressure sensitive adhesive layer 12 from each other, respectively.

The content of the second fine particles 122 contained in the first layer with respect to the total mass of the first layer is preferably from 0 to 50% by mass where a layer coming in contact with the substrate 15 is denoted as the first layer between the first layer and the second layer. The content of the second fine particles 122 contained in the second layer with respect to the total mass of the second layer is preferably from 0 to 50% by mass where a layer that is disposed on the first layer is denoted as the second layer.

There is a tendency that the adhesive force between the substrate 15 and the first layer is weaker than the adhesive force between the first layer and the second layer and the adhesive force between the second layer and the EL light emitting device adhering to the second layer in a case in which the content of the second fine particles 122 contained in the first layer with respect to the total mass of the first layer is from 0 to 20% by mass and the content of the second fine particles 122 contained in the second layer is from 0 to 20% by mass. There is a tendency that the adhesive force between the second layer and the EL light emitting device adhering to the second layer is weaker than the adhesive force between the substrate 15 and the first layer and the adhesive force between the first layer and the second layer in a case in which the content of the second fine particles 122 contained in the first layer with respect to the total mass of the first layer is from 0 to 20% by mass and the content of the second fine particles 122 contained in the second layer is from 20 to 50% by mass.

There is a tendency that the adhesive force between the first layer and the second layer is weaker than the adhesive force between the substrate 15 and the first layer and the adhesive force between the second layer and the EL light emitting device adhering to the second layer in a case in which the content of the second fine particles 122 contained in the first layer with respect to the total mass of the first layer is from 20 to 50% by mass and the content of the second fine particles 122 contained in the second layer is from 0 to 5% by mass.

The magnitude of the adhesive force can be appropriately set. There are the following advantages in the surface light emitting body or the production thereof as the magnitude of the adhesive force is controlled.

It is possible to fabricate a surface light emitting body forming a firm adhesive surface with the glass substrate of the EL light emitting device since the adhesive force with the EL light emitting device adhering to the second layer is strong in a case in which the adhesive force between the substrate 15 and the first layer is weak or the adhesive force between of the first layer and the second layer is weak.

It is possible to improve the productivity at the time of producing the surface-emitting body since the optical film is not fractured even in a case in which the optical film is required to be bonded again to the glass substrate of the EL light emitting device in a case in which the adhesive force between the optical film and the EL light emitting device adhering to the second layer is weak.

The protective film 17 may be provided on the surface having the pressure sensitive adhesive layer 12 of the optical film 10 of the invention, in order to protect the pressure sensitive adhesive layer 12 and to improve the handling property of the optical film 10. In other words, the optical film of the invention may be an optical film which includes a relief structure layer that forms one surface of the optical film and a pressure sensitive adhesive layer that forms the other surface of the optical film, in which the relief structure layer contains first light-diffusing fine particles at from 1 to 28% by mass with respect to the total mass of the relief structure layer and the pressure sensitive adhesive layer contains second light-diffusing fine particles at from 1 to 40% by mass with respect to the total mass of the pressure sensitive adhesive layer, and which further includes a protective film positioned on the pressure sensitive adhesive layer.

The protective film 22 may be peeled off from the optical film 10 when bonding the optical film 10 on the surface of the EL light emitting device 30.

Examples of the protective film 22 may include a known protective film.

### (Method for producing optical film 10)

The method for producing the optical film 10 of the invention may include a method to use an apparatus 50 as illustrated in Fig. 5.

Hereinafter, the method for producing the optical film 10 of the invention using the apparatus 50 illustrated in Fig. 5 will be described, but the method is not limited to the producing method using the apparatus 50 illustrated in Fig. 5.

An active energy ray resin composition to be a starting material of the material 111 constituting the relief structure layer 11, the first fine particles 112 contained in the relief structure layer 11, and if necessary, other components are mixed in the desired blending amounts, and a mixture 51 thus obtained is put in a storage tank 55 in advance.

The substrate 15 having the pressure sensitive adhesive layer 12 stacked thereon is introduced into between a cylindrical roll die 52 for forming the relief structure 13 and a rubber nip roll 53. In this state, the mixture 51 is supplied from the tank 55 to between the rotating roll die 52 and the substrate 15 having the pressure sensitive adhesive layer 12 stacked thereon through a pipe 56 having a nozzle attached to the tip.

The mixture 51 sandwiched between the rotating roll die 52 and the substrate 15 having the pressure sensitive adhesive layer 12 stacked thereon is cured by an active energy ray in the vicinity of an active energy ray irradiating apparatus 54. The cured product thus obtained is released from the roll die 52, thereby obtaining the optical film 10.

The viscosity of the mixture 51 is preferably from 10 to 3000 mPa·s, more preferably from 20 to 2500 mPa·s, and even more preferably from 30 to 2000 mPa·s from the viewpoint of excellent handling property at the time of producing the optical film 10.

Examples of the roll die 52 may include a die fabricated from a metal such as aluminum, brass, or steel; a die fabricated from a resin such as a silicone resin, a urethane resin, an epoxy resin, an ABS resin, a fluorocarbon resin, or a polymethylpentene resin; a die obtained by plating a resin; and a die fabricated from a material obtained by mixing various kinds of metal powders with a resin. Among these roll dies 52, a metal die is preferable since it exhibits excellent heat resistance or mechanical strength and is suitable for continuous production. Specifically, a metal die is preferable in many respects that it is strong to polymerization heat generation, hardly deforms, is hardly scratched, can have a temperature controlled, and is suitable for precision molding.

It is required to form a transfer surface having a protrusion or a recess for forming the relief structure 13 of the optical film 10 on the roll die 52.

Examples of the method for producing the transfer surface may include cutting by a diamond byte and etching as described in WO 2008/069324 A. Among these methods for producing the transfer surface, etching as described in WO 2008/069324 A is preferable from the viewpoint of being easy to form a protrusion or recess having a curved surface.

In addition, as the method for producing the transfer surface, it is possible to use a method to produce the cylindrical roll die 52 by winding a metal thin film fabricated from a master die having an inverted protrusion or recess of the protrusion or recess on the transfer surface using an electroforming method onto a roll core member.

A heat source equipment such as a sheath heater or a hot water jacket may be provided to the inside or outside of the roll die 52 in order to maintain the surface temperature if necessary.

Examples of the active energy ray irradiated from the active energy ray irradiating apparatus 54 may include ultraviolet light, an electron beam, X-ray, infrared rays, and visible light. Among these active energy rays, ultraviolet light and an electron beam are preferable and ultraviolet light is more preferable from the viewpoint of excellent curability of the active energy ray-curable composition and being able to suppress deterioration of the optical film 10.

Examples of the light emitting source of the active energy ray of the active energy ray irradiating apparatus 54 may include a chemical lamp, a low pressure mercury lamp, a high pressure mercury lamp, a metal halide lamp, an electrodeless ultraviolet lamp, a visible light halogen lamp, and a xenon lamp.

The integrated light quantity of the active energy ray irradiated from the active energy ray irradiating apparatus 54 is not particularly limited, but it is preferably from 0.01 to 10 J/cm² and more preferably from 0.5 to 8 J/cm² from the viewpoint of excellent curability of the active energy ray-curable composition and being able to suppress deterioration of the optical film 10.

A heat source equipment such as a sheath heater or a hot water jacket may be provided to the inside or outside of the tank 55 in order to maintain the storage temperature of the mixture 51 if necessary.

In other words, as an aspect of the invention, the method for producing an optical film includes providing a pressure sensitive adhesive layer containing second light-diffusing fine particles at from 1 to 40% by mass with respect to a total mass of the pressure sensitive adhesive layer on one surface of a substrate and providing a relief structure layer containing first light-diffusing fine particles at from 1 to 28% by mass with respect to a total mass of the relief structure layer on the other surface of the substrate.

In addition, as another aspect of the invention, the method for producing an optical film includes stacking a pressure sensitive adhesive layer containing second light-diffusing fine particles at from 1 to 40% by mass with respect to a total mass of the pressure sensitive adhesive layer on one surface of a substrate, coating a relief structure layer containing first light-diffusing fine particles at from 1 to 28% by mass with respect to a total mass of the relief structure layer on the other surface of the substrate, and curing it.

The optical film 10 described above can be provided on the light-exiting side of the surface light emitting body to be described later. Specifically, the optical film 10 can be provided on the light-exiting side of an EL light emitting device so as to be utilized as a flat panel display or as a luminaire.

### (Surface light emitting body)

The surface light emitting body of the invention includes the optical film 10 of the invention.

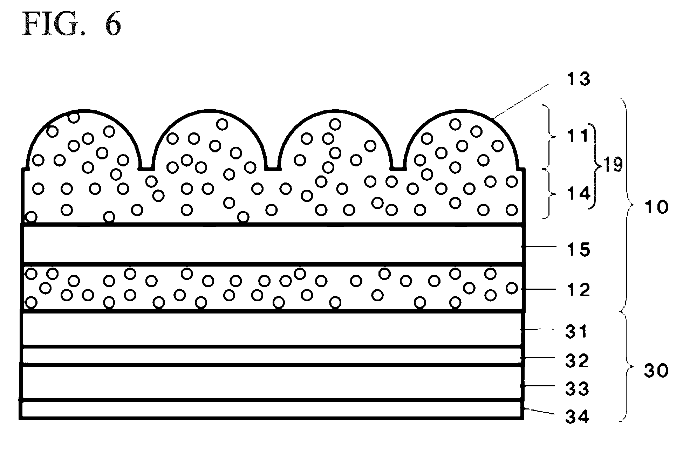

Examples of the surface light emitting body of the invention may include a surface light emitting body as illustrated in Fig. 6.

Hereinafter, the surface light emitting body of the invention illustrated in Fig. 6 will be described, but the surface light emitting body of the invention is not limited to the surface light emitting body illustrated in Fig. 6.

The surface light emitting body illustrated in Fig. 6 includes an EL light emitting device 30 fabricated by sequentially stacking a glass substrate 31, an anode 32, a light emitting layer 33, and a cathode 34, a pressure sensitive adhesive layer 21, and the optical film 10. The optical film 10 is provided on the surface on the side opposite to the surface on which the EL light emitting device 30 is formed of the glass substrate 31 via the pressure sensitive adhesive layer 21.

The surface light emitting body fabricated by providing the optical film 10 of the invention to the EL light emitting device 30 exhibits excellent productivity, has an improved light extraction efficiency or normal brightness, and exhibits suppressed exiting angle dependency of the exited light wavelength.

Incidentally, another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 1 to 28% by mass with respect to a total mass of the relief structure layer, the pressure sensitive adhesive layer contains second light-diffusing fine particles at from 1 to 40% by mass with respect to a total mass of the pressure sensitive adhesive layer, a material constituting the relief structure layer is an acrylic resin, and a material constituting the pressure sensitive adhesive layer is an acrylic pressure sensitive adhesive.

Another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 1 to 28% by mass with respect to a total mass of the relief structure layer, the pressure sensitive adhesive layer contains second light-diffusing fine particles at from 1 to 40% by mass with respect to a total mass of the pressure sensitive adhesive layer, a material constituting the relief structure layer is an acrylic resin, a material constituting the pressure sensitive adhesive layer is an acrylic pressure sensitive adhesive, and the first light-diffusing fine particles and the second light-diffusing fine particles are a silicone resin.

Another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 5 to 20% by mass with respect to a total mass of the relief structure layer, the pressure sensitive adhesive layer contains second light-diffusing fine particles at from 1 to 40% by mass with respect to a total mass of the pressure sensitive adhesive layer, a material constituting the relief structure layer is an acrylic resin, and a material constituting the pressure sensitive adhesive layer is an acrylic pressure sensitive adhesive.

Another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 1 to 28% by mass with respect to a total mass of the relief structure layer, the pressure sensitive adhesive layer contains second light-diffusing fine particles at from 2 to 30% by mass with respect to a total mass of the pressure sensitive adhesive layer, a material constituting the relief structure layer is an acrylic resin, a material constituting the pressure sensitive adhesive layer is an acrylic pressure sensitive adhesive.

Another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 5 to 20% by mass with respect to a total mass of the relief structure layer, the pressure sensitive adhesive layer contains second light-diffusing fine particles at from 2 to 30% by mass with respect to a total mass of the pressure sensitive adhesive layer, a material constituting the relief structure layer is an acrylic resin, a material constituting the pressure sensitive adhesive layer is an acrylic pressure sensitive adhesive.

Another aspect of the optical film 10 of the invention may be an optical film which includes a relief structure layer forming one surface of the optical film and a pressure sensitive adhesive layer forming the other surface of the optical film, and in which the relief structure layer contains first light-diffusing fine particles at from 1 to 28% by mass with respect to a total mass of the relief structure layer, the pressure sensitive adhesive layer contains second light-diffusing fine particles at from 1 to 40% by mass with respect to a total mass of the pressure sensitive adhesive layer, a material constituting the relief structure layer is an acrylic resin, a material constituting the pressure sensitive adhesive layer is an acrylic pressure sensitive adhesive, and a ratio of a content of the second light-diffusing fine particles contained in the pressure sensitive adhesive layer with respect to a total mass of the pressure sensitive adhesive layer to a content of the first light-diffusing fine particles contained in the relief structure layer with respect to a total mass of the relief structure layer is from 0.18 to 10.

### EXAMPLES

Hereinafter, the invention will be specifically described with reference to Examples, but the invention is not limited to these Examples.

Incidentally, the "parts" and "%" in Examples indicate the "parts by mass" and "% by mass", respectively.

### (Evaluation of warpage)

The optical films obtained in Examples and Comparative Examples were cut into a piece having a size of 13 cm² and allowed to stand on a flat surface so that the surface having a relief structure faced up. In this state, the distance from the flat surface to the respective four corners of the optical film was measured using a ruler, and the average value of the distances was adopted as the quantity of warpage of the optical film.

### (Measurement of light extraction efficiency)

A light shielding sheet which had a hole with a diameter of 10 mm and a thickness of 0.1 mm was disposed on the surface light emitting bodies obtained in Examples, Comparative Examples, and Reference Example, and this was disposed on the sample opening of an integrating sphere (manufactured by Labsphere, Inc., size: 6 inches). In this state, the light exiting through the hole with a diameter of 10 mm of the light shielding sheet when the integrating sphere was lit by applying a current of 10 mA to the organic EL light emitting device was measured using a spectroscopic measuring instrument (spectrometer: model name "PMA-12" (manufactured by Hamamatsu Photonics K.K.), software: software name "basic software U6039-01 ver.3.3.1 for PMA"), the correction was conducted by the standard luminosity curve, and the number of photons of the surface light emitting body was calculated.

The proportion of the number of photons of the surface light emitting bodies obtained in Examples and Comparative Examples with respect to 100% of the number of photons of the surface-emitting body obtained in Reference Example was adopted as the light extraction efficiency.

### (Measurement of normal brightness)

A light shielding sheet which had a hole with a diameter of 10 mm and a thickness of 0.1 mm was disposed on the surface light emitting bodies obtained in Examples, Comparative Examples, and Reference Example. In this state, the light exiting through the hole with a diameter of 10 mm of the light shielding sheet when the integrating sphere was lit by applying a current of 10 mA to the organic EL light emitting device was measured in the normal direction of the surface light emitting body using a luminance meter (model name "BM-7" manufactured by Topcon Corporation) to obtain the brightness value of the surface light emitting body.

The proportion of the brightness value of the surface light emitting bodies obtained in Examples and Comparative Examples with respect to 100% of the brightness value of the surface-emitting body obtained in Reference Example was adopted as the normal brightness.

### (Measurement of quantity of change in chromaticity)

A light shielding sheet which had a hole with a diameter of 10 mm and a thickness of 0.1 mm was disposed on the surface light emitting body obtained in Examples, Comparative Examples, and Reference Example. In this state, the light exiting through the hole with a diameter of 10 mm of the light shielding sheet when the integrating sphere was lit by applying a current of 10 mA to the organic EL light emitting device was measured using a luminance meter (model name "BM-7" manufactured by Topcon Corporation) to determine the chromaticity u' and v' of the L*u*v* color space in each of the normal direction (0°) of the surface light emitting body, the direction inclining by 10° with respect to the normal direction of the surface light emitting body, the direction inclining by 20° with respect to the normal direction of the surface light emitting body, the direction inclining by 30° with respect to the normal direction of the surface light emitting body, the direction inclining by 40° with respect to the normal direction of the surface light emitting body, the direction inclining by 50° with respect to the normal direction of the surface light emitting body, the direction inclining by 60° with respect to the normal direction of the surface light emitting body, the direction inclining by 70° with respect to the normal direction of the surface light emitting body, the direction inclining by 75° with respect to the normal direction of the surface light emitting body, and the direction inclining by 80° with respect to the normal direction of the surface light emitting body. The u' values at the respective angles and the average u' value were plotted on the horizontal axis, the v' values at the respective angles and the average v' value were plotted on the vertical axis, the distances from the points denoting the average u' value and the average v' value to the points denoting the u' values at the respective angles and the v' values at the respective angles were calculated, and the value at which the distance is the longest was adopted as the quantity of change in chromaticity.

Incidentally, it means that the exiting angle dependency of the exited light wavelength in the surface light emitting body is more suppressed as the quantity of change in chromaticity is smaller.

### (Measurement of peel force)

The polyethylene terephthalate substrate (protective film) coated with a release agent was peeled off from the pressure sensitive adhesive layer-stacked substrate obtained in Example, and the pressure sensitive adhesive layer-stacked substrate was bonded to the glass wiped with an alcohol using a roller of 2 kg and allowed to stand for 24 hours in a room at 23 ± 5°C and RH of 60 ± 20%.

The pressure sensitive adhesive layer-stacked substrate was peeled off at a tensile speed of 300 mm/min in 180° direction using a 180 degree peel strength tester, IPT200-50N (manufactured by IMADA CO., LTD) while holding the polyethylene terephthalate substrate. The sampling part was the central portion of the width direction end of the pressure sensitive adhesive layer-stacked substrate. The average value of the values obtained by measuring the peel force two times was adopted as the value of peel force.

### (Materials)

Pressure sensitive adhesive solution A: pressure sensitive adhesive solution prepared in Example 1 to be described later (refractive index after drying: 1.47)
Active energy ray-curable composition A: active energy ray-curable composition prepared in Example 1 to be described later (refractive index of cured product: 1.52)
Fine particles A: silicone resin spherical fine particles (trade name: "Tospearl 120" manufactured by Momentive Performance Materials, Inc., refractive index: 1.42, volume average particle size: 2 µm)
Fine particles B: crosslinked polymethyl methacrylate fine particles (trade name: "MBX-8" manufactured by SEKISUI PLASTICS CO., LTD., refractive index: 1.49, volume average particle size: 8 µm)
Fine particles C: crosslinked polystyrene fine particles (trade name: "SBX-8", SEKISUI PLASTICS CO., LTD., refractive index: 1.59, volume average particle size: 8 µm) and
Organic EL light emitting device A: organic EL light emitting device prepared by peeling off the optical film on the surface of the light-exiting surface side of the Symfos OLED-010K (manufactured by Konica Minolta, Inc., white OLED device)

### [Reference Example 1]

The organic EL light emitting device A was used as the surface light emitting body as it was.

### [Example 1]

### (Preparation of pressure sensitive adhesive solution A)

In ethyl acetate, 99 parts of n-butyl acrylate, 1 part of 2-hydroxyethyl acrylate, and 0.2 part of azobisisobutyronitrile were dissolved and reacted for 5 hours at 70°C, thereby obtaining an acrylic resin solution having a solid content of 30%. The pressure sensitive adhesive solution A was obtained by adding 0.5 part of trimethylolpropanetolylene diisocyanate to 100 parts of solid content of the acrylic resin solution thus obtained.

### (Preparation of mixture A)

The pressure sensitive adhesive solution A and the fine particles A were mixed together at 98% and 2%, respectively, thereby obtaining a mixture A.

### (Preparation of pressure sensitive adhesive layer-stacked substrate)

The mixture A thus obtained was coated on the release agent-coated surface of the release film formed of a polyethylene terephthalate substrate (protective film) that was 38 µm thick and had one surface coated with a silicone release agent using a comma coater such that the thickness of the pressure sensitive adhesive layer after drying became 25 µm, dried for 1 minute at 100°C, and bonded to a polyethylene terephthalate substrate (trade name "DIAFOIL T910E125" manufactured by Mitsubishi Plastics, Inc.) having a thickness of 125 µm, thereby obtaining a pressure sensitive adhesive layer-stacked substrate.

### (Preparation of active energy ray-curable composition A)

Into a glass flask, 117.6 g (0.7 mol) of hexamethylene diisocyanate and 151.2 g (0.3 mol) of an isocyanurate type hexamethylene diisocyanate trimer as the diisocyanate compound, 128.7 g (0.99 mol) of 2-hydroxypropyl acrylate and 693 g (1.54 mol) of pentaerythritol triacrylate as the hydroxyl group-containing (meth)acrylate, 22.1 g of din-butyltin dilaurate as the catalyst, and 0.55 g of hydroquinone monomethyl ether as the polymerization inhibitor were introduced, and the temperature thereof was raised to 75°C, and the mixture was continuously stirred while maintaining at 75°C to react until the concentration of residual isocyanate compound in the flask reached 0.1 mol/L or less and then cooled to room temperature, thereby obtaining a urethane polyfunctional acrylate.

The active energy ray-curable resin composition A was obtained by mixing 35 parts of the urethane polyfunctional acrylate thus obtained, 20 parts of a dimethacrylate represented by the following Formula (1) (trade name "ACRYESTER PBOM" manufactured by Mitsubishi Rayon Co., Ltd.), 40 parts of a dimethacrylate represented by the following Formula (2) (trade name "NEW FRONTIER BPEM-10" manufactured by DKS Co., Ltd.), 5 parts of an acrylate represented by the following formula (3) (trade name "NEW FRONTIER PHE" manufactured by DKS Co., Ltd.), and 1.2 parts of 1-hydroxycyclohexyl phenyl ketone (trade name "Irgacure 184" manufactured by BASF) together.

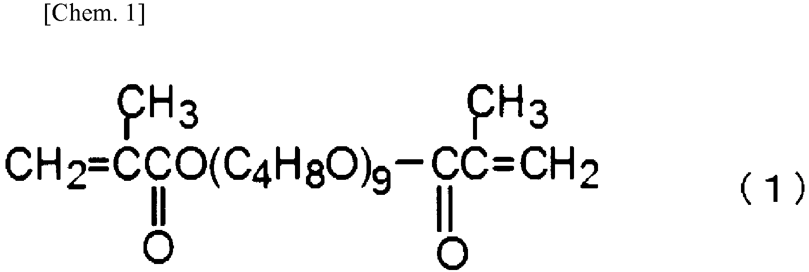

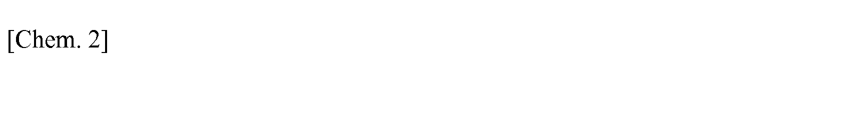

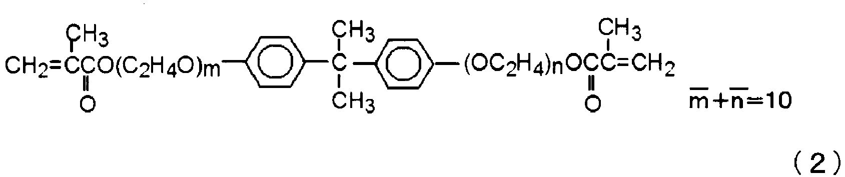

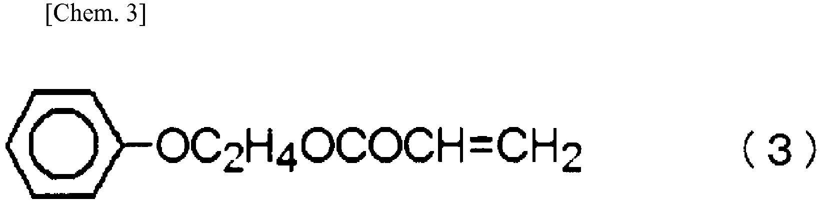

### (Preparation of mixture B)

The active energy ray-curable resin composition A and the fine particles A were mixed together at 80% and 20%, respectively, thereby obtaining a mixture B.

### (Production of roll die)

The outer circumferential surface of a steel roll having an outer diameter of 200 mm and a length in the axial direction of 320 mm was plated with copper to form a plated layer having a thickness of 200 µm and the Vickers hardness of 230 Hv. A photosensitive agent was coated on the surface of the copper plated layer, and the resultant was exposed to a laser beam, developed, and etched, thereby obtaining a die having a transfer portion in which a hemispherical recess having a diameter of 50 µm and a depth of 25 µm were lined on the copper plated layer in a hexagonal arrangement at a minimum interval of 10 µm formed. The surface of the die thus obtained was plated with chromium in order to impart corrosion resistance and durability, thereby obtaining a roll die.

### (Production of optical film)

The mixture B thus obtained was coated on the roll die thus obtained, the pressure sensitive adhesive layer-stacked substrate thus obtained was disposed thereon such that the mixture B is present on the surface opposite to the surface of the pressure sensitive adhesive layer, and the resultant was uniformly stretched using the nip roll so that the base layer had a thickness of 20 µm. Thereafter, the mixture B sandwiched between the roll die and the substrate was irradiated with ultraviolet light from above the substrate so as to be cured, the cured product of the mixture B was peeled off from the roll die, thereby obtaining an optical film.

As the size of the relief structure of the optical film calculated from the image taken using an electron microscope, the average longest diameter, Aave, was 49.5 µm and the average height, Bₐᵥₑ, was 25.9 µm, and a protrusion that almost corresponded to the size of the recess of the roll die and had a spherical segment shape was obtained. In addition, from the image taken using an electron microscope, it was confirmed that the relief structure of the optical film thus obtained was lined in a hexagonal arrangement at a minimum interval of 10 µm to correspond to the roll die and the proportion of the area of the bottom surface portion of the spherical protrusion with respect to the area of the optical film was 76%.

### (Production of surface light emitting body)

The polyethylene terephthalate substrate (protective film) coated with a release agent was peeled off from the optical film thus obtained, and the surface of the pressure sensitive adhesive layer was allowed to optically adhere on the light-exiting surface side of the organic EL light emitting device A, thereby obtaining a surface light emitting body. The quantity of warpage of the optical film thus obtained, the light extraction efficiency, normal brightness, and quantity of change in chromaticity of the surface light emitting body thus obtained are presented in Table 1.

### [Examples 2 to 6 and Comparative Examples 1 to 5]

The optical films and the surface light emitting bodies were obtained by conducting an operation in the same manner as in Example 1 except that the composition of the relief structure layer or the pressure sensitive adhesive layer was changed to that presented in Table 1. The quantity of warpage of the optical films thus obtained, the light extraction efficiency, normal brightness, and quantity of change in chromaticity of the surface light emitting bodies thus obtained are presented in Table 1.

**[Table 1]**

| | Relief structure layer | | | | | Pressure sensitive adliesive layer | | | | | Evaluation result | | | |
|---|---|---|---|---|---|---|---|---|---|---|---|---|---|---|
| | Material | | Fine particles | | | Material | | Fine particles | | | Optical film | Surface light-emitting body | | |
| | Content (%) | Refractive index | Content (%) | Refractive index | Volume average particle size (mm) | Content (%) | Refractive index | Content (%) | Refractive index | Volume average particle size (mm) | Quantity of warpage (mm) | Efficiency of light extraction (%) | Normal brightness (%) | Quantity of cliange in chromaticity |
| Reference Example 1 | - | - | - | - | - | - | - | - | - | - | - | 100 | 100 | 0.0122 |
| Example 1 | 80 | 1.52 | 20 | 1.42 | 2 | 98 | 1.47 | 2 | 1.42 | 2 | 2.5 | 175.0 | 162.5 | 0.0023 |
| Example 2 | 80 | 1.52 | 20 | 1.42 | 2 | 96 | 1.47 | 4 | 1.42 | 2 | 3.0 | 176.5 | 163.0 | 0.0021 |
| Example 3 | 80 | 1.52 | 20 | 1.42 | 2 | 90 | 1.47 | 10 | 1.42 | 2 | 2.2 | 178.0 | 165.2 | 0.0020 |
| Example 4 | 80 | 1.52 | 20 | 1.42 | 2 | 80 | 1.47 | 20 | 1.42 | 2 | 2.8 | 177.0 | 166.0 | 0.0019 |
| Example 5 | 90 | 1.52 | 10 | 1.42 | 2 | 80 | 1.47 | 20 | 1.42 | 2 | 2.0 | 177.5 | 162.3 | 0.0030 |
| Example 6 | 95 | 1.52 | 5 | 1.42 | 2 | 70 | 1.47 | 30 | 1.42 | 2 | 1.1 | 175.5 | 162.0 | 0.0032 |
| Comparative Example 1 | 70 | 1.52 | 30 | 1.42 | 2 | 100 | 1.47 | - | - | - | 12.6 | 174.8 | 162.0 | 0.0020 |
| Comparative Example 2 | 70 | 1.52 | 30 | 1.42 | 2 | 90 | 1.47 | 10 | 1.42 | 2 | 10.2 | 176.8 | 164.5 | 0.0018 |
| Comparative Example 3 | 70 | 1.52 | 30 | 1.42 | 2 | 70 | 1.47 | 30 | 1.42 | 2 | 11.3 | 172.0 | 165.8 | 0.0016 |
| Comparative Example 4 | 80 | 1.52 | 20 | 1.42 | 2 | 100 | 1.47 | - | - | - | 3.6 | 175.5 | 160.1 | 0.0035 |
| Comparative Example 5 | 100 | 1.52 | - | - | - | 90 | 1.47 | 10 | 1.42 | 2 | 1.0 | 178.0 | 161.2 | 0.0059 |

### [Examples 7 to 12 and Comparative Examples 6 to 10]

The optical films and the surface light emitting bodies were obtained by conducting an operation in the same manner as in Example 1 except that the fine particles B were used instead of the fine particles A in the production of the mixture B and the composition of the relief structure layer or the pressure sensitive adhesive layer was changed to that presented in Table 2. The quantity of warpage of the optical films thus obtained, the light extraction efficiency, normal brightness, and quantity of change in chromaticity of the surface light emitting bodies thus obtained are presented in Table 2.

**[Table 2]**

| | Relief structure layer | | | | | Pressure sensitive adhesive layer | | | | | Evaluation result | | | |
|---|---|---|---|---|---|---|---|---|---|---|---|---|---|---|
| | Material | | Fine particles | | | Material | | Fine particles | | | Optical film | Surface light-emitting body | | |
| | Content (%) | Refractive index | Content (%) | Refractive index | Volume average particle size (mm) | Content (%) | Refractive index | Content (%) | Refractive index | Volume average particle size (mm) | Quantity of warpage (mm) | Efficiency of light extraction (%) | Normal brightness (%) | Quantity of change in chromaticity |
| Reference Example 1 | - | - | - | - | - | - | - | - | - | - | - | 100 | 100 | 0.0122 |
| Example 7 | 80 | 1.52 | 20 | 1.49 | 8 | 98 | 1.47 | 2 | 1.42 | 2 | 2.2 | 181.1 | 158.7 | 0.0054 |
| Example 8 | 80 | 1.52 | 20 | 1.49 | 8 | 96 | 1.47 | 4 | 1.42 | 2 | 3.2 | 179.7 | 159.1 | 0.0054 |
| Example 9 | 80 | 1.52 | 20 | 1.49 | 8 | 90 | 1.47 | 10 | 1.42 | 2 | 2.1 | 177.3 | 156.7 | 0.0053 |
| Example 10 | 80 | 1.52 | 20 | 1.49 | 8 | 80 | 1.47 | 20 | 1.42 | 2 | 2.5 | 178.2 | 161.2 | 0.0037 |
| Example 11 | 90 | 1.52 | 10 | 1.49 | 8 | 80 | 1.47 | 20 | 1.42 | 2 | 2.3 | 178.7 | 159.1 | 0.0041 |
| Example 12 | 95 | 1.52 | 5 | 1.49 | 8 | 70 | 1.47 | 30 | 1.42 | 2 | 1.5 | 179.6 | 159.5 | 0.0048 |
| Comparative Example 6 | 70 | 1.52 | 30 | 1.49 | 8 | 100 | 1.47 | - | - | - | 14.5 | 178.3 | 157.5 | 0.0051 |
| Comparative Example 7 | 70 | 1.52 | 30 | 1.49 | 8 | 90 | 1.47 | 10 | 1.42 | 2 | 11.3 | 178.3 | 159.1 | 0.0047 |
| Comparative Example 8 | 70 | 1.52 | 30 | 1.49 | 8 | 70 | 1.47 | 30 | 1.42 | 2 | 12.6 | 180.2 | 159.9 | 0.0043 |
| Comparative Example 9 | 80 | 1.52 | 20 | 1.49 | 8 | 100 | 1.47 | - | - | - | 2.5 | 177.9 | 155.6 | 0.0054 |
| Comparative Example 10 | 100 | 1.52 | - | - | - | 90 | 1.47 | 10 | 1.42 | 2 | 1.0 | 178.0 | 161.2 | 0.0059 |

### [Examples 13 to 18 and Comparative Examples 11 to 15]

The optical films and the surface light emitting bodies were obtained by conducting an operation in the same manner as in Example 1 except that the fine particles C were used instead of the fine particles A in the production of the mixture B and the composition of the relief structure layer or the pressure sensitive adhesive layer was changed to that presented in Table 3. The quantity of warpage of the optical films thus obtained, the light extraction efficiency, normal brightness, and quantity of change in chromaticity of the surface light emitting bodies thus obtained are presented in Table 3.

**[Table 3]**

| | Relief structure layer | | | | | Pressure sensitive adhesive layer | | | | | Evaluation result | | | |
|---|---|---|---|---|---|---|---|---|---|---|---|---|---|---|
| | Material | | Fine particles | | | Material | | Fine particles | | | Optical film | Surface light-emitting body | | |
| | Content (%) | Refractive index | Content (%) | Refractive index | Volume average particle size (mm) | Content (%) | Refractive index | Content (%) | Refractive index | Volume average particle size (mm) | Quantity of warpage (mm) | Efficiency of light extraction (%) | Normal brightness (%) | Quantity of change in chromaticity |
| Reference Example 1 | - | - | - | - | - | - | - | - | - | - | - | 100 | 100 | 0.0122 |
| Example 13 | 80 | 1.62 | 20 | 1.59 | 8 | 98 | 1.47 | 2 | 1.42 | 2 | 1.5 | 176.4 | 165.7 | 0.0039 |
| Example 14 | 80 | 1.62 | 20 | 1.59 | 8 | 96 | 1.47 | 4 | 1.42 | 2 | 2.5 | 178.1 | 162.3 | 0.0043 |
| Example 15 | 80 | 1.62 | 20 | 1.59 | 8 | 90 | 1.47 | 10 | 1.42 | 2 | 3.2 | 174.6 | 164.3 | 0.0037 |
| Example 16 | 80 | 1.62 | 20 | 1.59 | 8 | 80 | 1.47 | 20 | 1.42 | 2 | 2.4 | 171.1 | 167.6 | 0.0028 |
| Example 17 | 90 | 1.62 | 10 | 1.59 | 8 | 80 | 1.47 | 20 | 1.42 | 2 | 3.4 | 177.4 | 165.8 | 0.0032 |
| Example 18 | 95 | 1.62 | 5 | 1.59 | 8 | 70 | 1.47 | 30 | 1.42 | 2 | 1.2 | 178.4 | 162.9 | 0.0040 |
| Comparative Example 11 | 70 | 1.62 | 30 | 1.59 | 8 | 100 | 1.47 | - | - | - | 12.4 | 178.0 | 161.9 | 0.0039 |
| Comparative Example 12 | 70 | 1.62 | 30 | 1.59 | 8 | 90 | 1.47 | 10 | 1.42 | 2 | 13.8 | 178.1 | 163.2 | 0.0036 |
| Comparative Example 13 | 70 | 1.62 | 30 | 1.59 | 8 | 70 | 1.47 | 30 | 1.42 | 2 | 12.7 | 177.1 | 161.4 | 0.0045 |
| Comparative Example 14 | 80 | 1.62 | 20 | 1.59 | 8 | 100 | 1.47 | - | - | - | 1.2 | 177.9 | 161.0 | 0.0043 |
| Comparative Example 15 | 100 | 1.62 | - | - | - | 90 | 1.47 | 10 | 1.42 | 2 | 1.6 | 176.1 | 158.0 | 0.0056 |

### [Example 19]

### (Preparation of pressure sensitive adhesive layer-stacked substrate)

The mixture A of Example 1 was coated on the release agent-coated surface of the release film formed of a polyethylene terephthalate substrate (protective film) that was 38 µm thick and had one surface coated with a silicone release agent using a comma coater such that the thickness of the pressure sensitive adhesive layer after drying became 25 µm and dried for 1 minute at 100°C to form the pressure sensitive adhesive layer 2. Thereafter, the adhesive material solution A of Example 1 was coated on the pressure sensitive adhesive layer 2 using a comma coater such that the thickness of the pressure sensitive adhesive layer after drying became 25 µm and dried for 1 minute at 100°C to form the pressure sensitive adhesive layer 1. Thereafter, the resultant was bonded to a polyethylene terephthalate substrate (trade name "DIAFOIL T910E125" manufactured by Mitsubishi Plastics, Inc.) having a size of 25 mm × 150 mm and a thickness of 125 µm, thereby obtaining a pressure sensitive adhesive layer-stacked substrate. The peel force of the pressure sensitive adhesive layer-stacked substrate thus obtained is presented in Table 4.

Incidentally, in Table 4, it indicates that peeling of the pressure sensitive adhesive layer-stacked substrate has occurred at the interface between the polyethylene terephthalate substrate and the pressure sensitive adhesive layer 1 in a case in which there is a numerical value in the column of the "substrate-pressure sensitive adhesive layer 1" for the "peel force". In other words, it indicates that peeling has occurred at the interface between the polyethylene terephthalate substrate and the pressure sensitive adhesive layer 1 that is the interface having the smallest peel force among the interfaces between "polyethylene terephthalate substrate-pressure sensitive adhesive layer 1", "pressure sensitive adhesive layer 1-pressure sensitive adhesive layer 2", and "pressure sensitive adhesive layer 2-glass substrate" and the numerical value is the peel force measured.

It indicates that peeling has occurred at the interface between the pressure sensitive adhesive layer 1 and the pressure sensitive adhesive layer 2 in a case in which there is a numerical value in the column of the "pressure sensitive adhesive layer 1-pressure sensitive adhesive layer 2". In other words, it indicates that peeling has occurred at the interface between the pressure sensitive adhesive layer 1 and the pressure sensitive adhesive layer 2 that is the interface having the smallest peel force among the interfaces between "polyethylene terephthalate substrate-pressure sensitive adhesive layer 1", "pressure sensitive adhesive layer 1-pressure sensitive adhesive layer 2", and "pressure sensitive adhesive layer 2-glass substrate" and the numerical value is the peel force measured.

It indicates that peeling has occurred at the interface between the pressure sensitive adhesive layer 2 and the glass substrate in a case in which there is a numerical value in the column of the "pressure sensitive adhesive layer 2-glass substrate". In other words, it indicates that peeling has occurred at the interface between the pressure sensitive adhesive layer 2 and the glass substrate that is the interface having the smallest peel force among the interfaces between "polyethylene terephthalate substrate-pressure sensitive adhesive layer 1", "pressure sensitive adhesive layer 1-pressure sensitive adhesive layer 2", and "pressure sensitive adhesive layer 2-glass substrate" and the numerical value is the peel force measured.

### [Examples 20 to 42]

The pressure sensitive adhesive layer-stacked substrates were obtained by conducting an operation in the same manner as in Example 19 except that the content of the fine particles A contained in the pressure sensitive adhesive layer 1 and the content of the fine particles A contained in the pressure sensitive adhesive layer 2 were changed to those presented in Table 4. The peel force of the pressure sensitive adhesive layer-stacked substrates thus obtained is presented in Table 4.

**[Table 4]**

| | Pressure sensitive adhesive layer 1 | Pressure sensitive adhesive layer 2 | Evaluation result | | | |
|---|---|---|---|---|---|---|
| | Content of fine particles (%) | Content of fine particles (%) | Peel force (N/25mm) | | | Presence or absence of residual pressure sensitive adhesive on glass substrate |
| | | | Substrate-pressure sensitive adhesive layer 1 | Pressure sensitive adhesive layer 1-pressure sensitive adhesive layer 2 | Pressure sensitive adhesive layer 2-glass substrate | |
| Example 19 | 0 | 2 | 2.7 | - | - | Presence |
| Example 20 | 0 | 4 | 1.4 | - | - | Presence |
| Example 21 | 0 | 10 | 1.6 | - | - | Presence |
| Example 22 | 0 | 30 | - | - | 4.6 | Absence |
| Example 23 | 2 | 0 | 4.2 | - | - | Presence |
| Example 24 | 2 | 2 | 2.1 | - | - | Presence |
| Example 25 | 2 | 4 | 1.5 | - | - | Presence |
| Example 26 | 2 | 10 | 1.5 | - | - | Presence |
| Example 27 | 2 | 30 | - | - | 4.5 | Absence |
| Example 28 | 4 | 0 | 3.7 | - | - | Presence |
| Example 29 | 4 | 2 | 2.7 | - | - | Presence |
| Example 30 | 4 | 4 | 3.2 | - | - | Presence |
| Example 31 | 4 | 10 | 1.0 | - | - | Presence |
| Example 32 | 4 | 30 | - | - | 4.3 | Absence |
| Example 33 | 10 | 0 | 3.9 | - | - | Presence |
| Example 34 | 10 | 2 | 2.5 | - | - | Presence |
| Example 35 | 10 | 4 | 4.5 | - | - | Presence |
| Example 36 | 10 | 10 | 1.2 | - | - | Presence |
| Example 37 | 10 | 30 | - | - | 4.2 | Absence |
| Example 38 | 30 | 0 | - | 4.7 | - | Presence |
| Example 39 | 30 | 2 | - | 4.5 | - | Presence |
| Example 40 | 30 | 4 | - | 4.6 | - | Presence |
| Example 41 | 30 | 10 | - | - | 4.3 | Absence |
| Example 42 | 30 | 30 | - | - | 4.4 | Absence |

As can be seen from Table 1, the optical films obtained in Examples 1 to 6 had a small quantity of warpage, the light extraction efficiency and normal brightness of the surface light emitting bodies were excellent, and the exiting angle dependency of the exited light wavelength in the surface light emitting bodies was suppressed. On the other hand, the optical films obtained in Comparative Examples 1 to 3 had a great quantity of warpage, the surface light emitting body obtained in Comparative Example 4 had a poor normal brightness, and the suppression of exiting angle dependency of the exited light wavelength in the surface light emitting body obtained in Comparative Example 5 was insufficient.

As can be seen from Table 2, the optical films obtained in Examples 7 to 12 had a small quantity of warpage, the light extraction efficiency and normal brightness of the surface light emitting bodies were excellent, and the exiting angle dependency of the exited light wavelength in the surface light emitting bodies was suppressed. On the other hand, the optical films obtained in Comparative Examples 6 to 8 had a great quantity of warpage, the surface light emitting body obtained in Comparative Example 9 had a poor normal brightness, and the surface light emitting body obtained in Comparative Example 5 had a poor quantity of change in chromaticity.

As can be seen from Table 3, the optical films obtained in Examples 13 to 18 had a small quantity of warpage, the light extraction efficiency and normal brightness of the surface light emitting bodies were excellent, and the exiting angle dependency of the exited light wavelength in the surface light emitting bodies was suppressed. On the other hand, the optical films obtained in Comparative Examples 11 to 13 had a great quantity of warpage, the surface light emitting body obtained in Comparative Example 14 had a poor normal brightness, and the suppression of exiting angle dependency of the exited light wavelength in the surface light emitting body obtained in Comparative Example 15 was insufficient.

As can be seen from Table 4, peeling of the pressure sensitive adhesive layer-stacked substrates obtained in Examples 19 to 21, 23 to 26, 28 to 31, 33 to 36, and 38 to 40 has occurred at the interface between the polyethylene terephthalate substrate and the pressure sensitive adhesive layer 1 or at the interface between the pressure sensitive adhesive layer 1 and the pressure sensitive adhesive layer 2, and thus it can be said that the pressure sensitive adhesive force at the interface between the pressure sensitive adhesive layer 2 and the glass substrate is relatively great. In other words, it is possible to fabricate a surface light emitting body forming a firm adhesive surface with the glass substrate of an EL light emitting device by using the optical films of the invention including of the pressure sensitive adhesive layer-stacked substrates obtained in Examples 19 to 21, 23 to 26, 28 to 31, 33 to 36, and 38 to 40.

As can be seen from Table 4, peeling of the pressure sensitive adhesive layer-stacked substrates obtained in Examples 22, 27, 32, 37, 41, and 42 has occurred at the interface between the pressure sensitive adhesive layer 2 and the glass substrate. Hence, it is possible to improve the productivity at the time of producing the surface-emitting body since the optical film is not fractured even in a case in which the optical film is required to be bonded again to the glass substrate of an EL light emitting device.

### INDUSTRIAL APPLICABILITY

By the optical film of the invention, it is possible to obtain a surface light emitting body which has an excellent light extraction efficiency or normal brightness and exhibits suppressed exiting angle dependency of the exited light wavelength, and this surface light emitting body can be suitably used, for example, in lighting, a display, and a screen.

### EXPLANATIONS OF LETTERS OR NUMERALS

- 10: Optical film
- 11: Relief structure layer
- 111: Material constituting relief structure layer
- 112: Fine particles contained in relief structure layer
- 12: Pressure sensitive adhesive layer
- 121: Material constituting pressure sensitive adhesive layer
- 122: Fine particles contained in pressure sensitive adhesive layer
- 13: Relief structure
- 14: Base layer
- 15: Substrate
- 16: Bottom surface portion of relief structure
- 17: Protective film
- 30: EL light emitting device
- 31: Glass substrate
- 32: Anode
- 33: Light emitting layer
- 34: Cathode
- 50: Apparatus
- 51: Mixture
- 52: Roll die
- 53: Nip roll
- 54: Active energy ray irradiating apparatus
- 55: Tank
- 56: Pipe

## Claims

1. An optical film comprising a relief structure layer forming one surface of the optical film and a pressure sensitive adhesive layer forming the other surface of the optical film, wherein
the relief structure layer contains first light-diffusing fine particles at from 1 to 28% by mass with respect to a total mass of the relief structure layer and
the pressure sensitive adhesive layer contains second light-diffusing fine particles at from 1 to 40% by mass with respect to a total mass of the pressure sensitive adhesive layer.

2. The optical film according to claim 1, wherein a content of the second light-diffusing fine particles with respect to a total mass of the pressure sensitive adhesive layer is from 20 to 40% by mass.

3. The optical film according to claim 1 or 2, wherein a volume average particle size of the first light-diffusing fine particles contained in the relief structure layer is from 0.5 to 20 µm.

4. The optical film according to any one of claims 1 to 3, wherein a volume average particle size of the second light-diffusing fine particles contained in the pressure sensitive adhesive layer is from 0.5 to 20 µm.

5. The optical film according to any one of claims 1 to 4, wherein a difference between a refractive index of a material constituting the relief structure layer and a refractive index of the first light-diffusing fine particles contained in the relief structure layer is from 0.02 to 0.30.

6. The optical film according to any one of claims 1 to 5, wherein a difference between a refractive index of a material constituting the pressure sensitive adhesive layer and a refractive index of the second light-diffusing fine particles contained in the pressure sensitive adhesive layer is from 0.02 to 0.30.

7. The optical film according to any one of claims 1 to 6, wherein a ratio of a content of the second light-diffusing fine particles contained in the pressure sensitive adhesive layer with respect to a total mass of the pressure sensitive adhesive layer to a content of the first light-diffusing fine particles contained in the relief structure layer with respect to a total mass of the relief structure layer is from 0.05 to 10.

8. The optical film according to any one of claims 1 to 7, wherein a ratio of a volume average particle size of the second light-diffusing fine particles contained in the pressure sensitive adhesive layer to a volume average particle size of the first light-diffusing fine particles contained in the relief structure layer is from 0.125 to 1.25.

9. The optical film according to any one of claims 1 to 8, wherein a ratio of a refractive index of the second light-diffusing fine particles contained in the pressure sensitive adhesive layer to a refractive index of the first light-diffusing fine particles contained in the relief structure layer is from 0.80 to 1.05.

10. The optical film according to any one of claims 1 to 9, wherein the optical film further comprises a base layer coming in contact with the relief structure layer, and a total thickness of the relief structure layer and the base layer is from 20 to 80 µm.

11. The optical film according to any one of claims 1 to 10, wherein a thickness of the pressure sensitive adhesive layer is from 5 to 50 µm.

12. The optical film according to any one of claims 1 to 11, wherein a ratio of a volume average particle size of the second light-diffusing fine particles contained in the pressure sensitive adhesive layer to a thickness of the pressure sensitive adhesive layer is from 0.05 to 0.5.

13. The optical film according to any one of claims 1 to 12, wherein a material constituting the relief structure layer is at least one kind of material selected from the group consisting of an acrylic resin, a styrene resin, an olefin resin, a polycarbonate resin, a silicone resin, an epoxy resin, and a polyester resin.

14. The optical film according to any one of claims 1 to 13, wherein a material constituting the pressure sensitive adhesive layer is an acrylic pressure sensitive adhesive.

15. The optical film according to any one of claims 1 to 14, wherein a material of the first light-diffusing fine particles contained in the relief structure layer is at least one kind of material selected from the group consisting of a silicone resin, an acrylic resin, a styrene resin, a urethane resin, a melamine resin, and an epoxy resin.

16. The optical film according to any one of claims 1 to 15, wherein a material of the second light-diffusing fine particles contained in the pressure sensitive adhesive layer is at least one kind of material selected from the group consisting of a silicone resin, an acrylic resin, a styrene resin, a urethane resin, a melamine resin, and an epoxy resin.

17. The optical film according to any one of claims 1 to 16, wherein the optical film further comprises a substrate, and the pressure sensitive adhesive layer, the substrate, and the relief structure layer are sequentially stacked.

18. A surface light emitting body comprising the optical film according to any one of claims 1 to 17 and an EL light emitting device.

19. A method for producing an optical film, comprising:
providing a pressure sensitive adhesive layer containing second light-diffusing fine particles at from 1 to 40% by mass with respect to a total mass of the pressure sensitive adhesive layer on one surface of a substrate; and
providing a relief structure layer containing first light-diffusing fine particles at from 1 to 28% by mass with respect to a total mass of the relief structure layer on the other surface of the substrate.
